# EUROPÄISCHE PATENTSCHRIFT

(11) **EP 0 417 147 B1**
(45) Veröffentlichungstag und Bekanntmachung des Hinweises auf die Patenterteilung: **11.05.1994**
(21) Anmeldenummer: 89906026.3
(22) Anmeldetag: 30.05.1989
(51) Int. Cl.: H03D 3/00, H04B 1/16

(54) **FM-RUNDFUNKEMPFANGSTEIL**
FM RADIO RECEPTOR UNIT
ELEMENT DE RECEPTION RADIO FM

(30) Priorität: 30.05.1988 DE 3818753
(43) Veröffentlichungstag der Anmeldung: 20.03.1991
(73) Patentinhaber: H.U.C. ELEKTRONIK GMBH, D-13355 Berlin (DE)
(72) Erfinder: HANSEN, Jens, D-1000 Berlin 51 (DE)
(74) Vertreter: Christiansen, Henning, Dipl.-Ing.
(86) Internationale Anmeldenummer: DE8900358
(87) Internationale Veröffentlichungsnummer: WO8912354

(56) Entgegenhaltungen:
- WO-A-86/02505
- WO-A-88/08222
- WO-A-88/08223
- DE-A- 2 731 940
- DE-A- 2 929 647

## Beschreibung

Die Erfindung betrifft ein FM-Rundfunkempfangsteil der im Oberbegriff des Anspruchs 1 angegebenen Art.

Schaltungen dieser Art sind aus den DE-A-31 47 493 und 34 38 286, der EP-A-75 071 oder der FR-A-81 21 986 bekannt, welche sämtlich auf den Erfinder Jens Hansen zurückgehen.

Aus DE 27 31 940 A1 ist ein Stereo-FM-Empfänger mit einer Dämpfungsschaltung zum Unterbrechen oder Vermindern seines Wiedergabe-Ausgangssignals bei geringer elektrischer Feldstärke des Empfangssignals sowie einer Betriebsweisen- änderungsschaltung bekannt, mit der in Abhängigkeit von der Empfangsfeldstärke von Stereo- auf Mono-Wiedergabe umgeschaltet werden kann. Dieser Empfänger ist durch die vorab zitierten Druckschriften technisch überholt.

Aus EP 0 086 838 A1 ist ein Demodulierungssystem für Farbfernsehempfänger bekannt, bei dem bei geringer Empfangsfeldstärke sowohl die Bandbreite als auch die Mittenfrequenz eines einem herkömmlichen Bandfilter nachgeschalteten Bandfilters zur Erreichung einer verbesserten Selektivität verändert werden können. Dies geschieht wie bei den gattungsbildenden FM-Rundfunkempfängern aufgrund eines die Empfangsverhältnisse charakterisierenden Steuersignals, aus dem der Farbträgeranteil des Fernsehsignals gewonnen wird. Infolge der von einem Rundfunkempfänger grundverschiedenen Wiedergabecharakteristiken treten hier bestimmte, nachfolgend erläuterte Probleme des FM-Rundfunkempfangs gar nicht auf, so daß auch keine Maßnahmen zu deren Lösung angegeben sein können.

Die Leistungsfähigkeit konventioneller UKW-Empfänger wird den heutigen schwierigen Empfangsverhältnissen kaum noch gerecht. Durch die dichte Senderbelegung entsteht ein "spektraler Sumpf", der die Grenzen des Empfangskonzepts hinsichtlich Empfangsempfindlichkeit und Trennschärfe deutlich aufzeigt. Das Dilemma des UKW-Empfangs ist, daß das Spektrum eines frequenzmodulierten Signals keine scharfen Grenzen hat, sondern langsam ausläuft und dabei zwangsläufig trotz aller senderseitigen Begrenzungsmaßnahmen in die Nachbarkanäle hineinragt. Schon ein Stereosender mittlerer Feldstärke setzt die Grenzempfindlichkeit seiner benachbarten Sender deutlich herab. Ändern sich nun auch noch, wie im mobilen Betrieb, ständig die Empfangsverhältnisse, so sind Aufrauschen, Modulationsübernahme, Reflexionsverzerrungen das unvermeidliche Ergebnis.

Mit der konventionellen Filtertechnik läßt sich hieran nichts ändern, denn Störspektrallinien innerhalb des Empfangskanals sind nicht mehr selektierbar. Durch Einengung der Bandbreite zur Reduzierung von Multipathstörungen würde zwar ein Teil des Störspektrums, aber auch ein Teil des Nutzspektrums außerhalb des Filters liegen, so daß die Empfangsempfindlichkeit zurückginge.

Bei dem in den eingangs genannten Schriften beschriebenen bekannten Verfahren zur Verarbeitung von FM-Signalen im ZF-Bereich werden steuerbare schmalbandige Filter verwendet. Die in ihrer Resonanzlage steuerbaren schmalbandigen Filter vollziehen den gleichen Rhythmus wie das zu selektierende ZF-Signal; sie folgen also der Momentan-ZF, so daß zu jedem Moment genau nur dort selektiert wird, wo gerade Selektion erforderlich ist. Aufgrund der Schmalbandigkeit der verwendeten Filter ergeben sich hohe Empfindlichkeits-und Selektionssteigerungen.

Die Steuerspannung für die Resonanzfrequenz der Filter wird aus der Niederfrequenz abgeleitet, deren Pegel ein hinreichendes Maß für die Position der Momentan-ZF ist. Diese Positionsangabe kann allerdings aus prinzipiellen Gründen nicht exakt sein, denn bevor die Filter gesteuert werden, muß die ZF diese zunächst durchlaufen und anschließend demoduliert werden. Die Steuerung erfolgt also stets mit einer gewissen Verzögerung, die im wesentlichen durch die Gruppenlaufzeit der Filter gegeben ist. Je schmalbandiger die Filter ausgelegt werden, desto höher ist deren Gruppenlaufzeit. Bei einfachen Mitlauffilterverfahren oder den bekannten PLL- oder Synchronverfahren würde diese Nachlaufverzögerung im höheren Niederfrequenzbereich dazu führen, daß die Bewegung des ZF-Signals und die der Filter entgegengerichtet verlaufen. Ein Mitlaufen der Filter im unteren NF-Bereich würde einem Gegenlaufen im oberen NF-Bereich gegenüberstehen, so daß letztlich eine Breitband- übertragung nicht möglich wäre.

Der Erfindung liegt also die Aufgabe zugrunde, die Empfangsempfindlichkeit und die Trennscharfe beträchtlich zu steigern, ohne andere Empfängerdaten, wie Klirrfaktor, Stereo-Übersprechen oder NF-Frequenzgang zu beeinträchtigen.

Diese Aufgabe wird mit den kennzeichnenden Merkmalen des Anspruchs 1 gelöst.

Die Erfindung beruht auf der Erkenntnis, daß für den optimierten Betrieb eines ICS-Systems eine kontinuierliche Anpassung an das aktuelle Eingangssignalstörbild günstig ist, die auf der logischen Verknüpfung mehrerer Eingangssignale, welche aus dem zu optimierenden Verarbeitungskanal abgeleitet werden und für bestimmte Störungen charakteristisch sind unter logischer Verknüpfung erfolgt, wobei jedem "Störungsbild" ein Satz von Steuergrößen zugeordnet wird, welche ein auf dieses Störungsbild zugeschnittenen Verarbeitungskanal durch entsprechende Schaltsignale erzeugen.

In günstiger Weiterbildung hat bei der logischen Verknüpfung jeweils ein solches Eingangssignalstörbild, welches zu einer schmalbandigeren Durchlaßcharakteristik des Verarbeitungskanals Vorrang vor solchen Schaltverknüpfungen, die zu einer breitbandigeren Charakteristik führen.

Bei jedem "Störbild" haben diejenigen Signale Priorität, die zu der schmalbandigsten ZF-Durchlaßcharakteristik führen und es wird die entsprechende Verarbeitungscharakteristik gewählt.

In einer zweistufigen Verarbeitung werden zunächst Signale ermittelt, welche für einen betreffenden Störzustand besonders charakteristisch sind. Diese Signale rufen dann "Wahrheitstabellen" auf, durch die in Form von logischen Verknüpfungen zu den betreffenden definierten Störzuständen Schaltmaßnahmen eingeleitet werden, welche dem festgestellten Störzustand optimal entgegenwirken. Jedem ermittelten Störzustand können auf diese Weise mehrere Schaltmaßnahmen zugeordnet werden.

Verändert sich die Bedämpfung der ZF-Filter, so wird durch entsprechende Kompensationsmaßnahmen sichergestellt, daß der ZF-Pegel konstant bleibt.

Die momentane Empfangssituation ist im wesentlichen gekennzeichnet durch:
- die Lage der Momentan-ZF
- den Pegel der Empfangsfeldstärke
- den Pegel von Nachbarkanalstörungen und Störungen, die im Nutzkanal liegen.

Hierzu sind bevorzugt die folgenden Erkennungsschaltungen Vorgesehen:
1. für Nachbarkanalstörungen
2. für die Nachbarkanalübernahme
3. für Reflexionsstörungen
4. für den Feldstärkepegel

Über eine logische Schaltung werden die Ausgänge der Erkennungsschaltungen mit den Steuereingängen der Filter verknüpft.

Die ZF-Filteranordnung besteht bevorzugt aus einem einkreisigen Vorfilter bei 10,7 MHz, einer Mischstufe zur Umsetzung von 10,7 MHz auf 700 kHz, einem anschließenden zweikreisigen Bandfilter, sowie zwei dem Bandfilter nachgeschalteten, auf 700 kHz abgestimmten Einzelkreisen.

Die Ausgänge des Bandfilters und der Einzelkreisschaltung gelangen jeweils über einen Schalter auf eine Addierstufe, deren Ausgang mit dem Demodulator verbunden ist. Die Oszillatorspannung wird über mindestens einen Einzelkreis der Mischstufe zugeführt.

Gesteuert werden bei der Filteranordnung
1. die Resonanzlage des Vorfilters des Bandfilters und der Einzelfilter synchron zur Momentan-ZF
2. die Phasenlage der Oszillatorspannung gegenphasig zur Momentan-ZF
3. die Bedämpfung des Bandfilters
4. die Bedämpfung der Einzelfilter
5. die Summierung von Signalen verschiedenen Verarbeitungswege

### Im einzelnen erfolgen vorteilhafte Steuerungen wie folgt:

Die Steuerspannungen für die Resonanzlage der Filter werden aus dem NF-Signal abgeleitet, deren Pegel ein Maß für die Frequenzlage des momentanen ZF-Signals ist. Diese Positionsangabe weist jedoch einen geringen Fehler auf, denn bevor die Filter gesteuert werden, muß die ZF diese zunächst durchlaufen haben und anschließend demoduliert werden. Die Steuerspannung steht also nicht zeitgleich zu einer ZF-Änderung zur Verfügung, sondern erst nach einer gewissen Verzögerung, die im wesentlichen durch die Gruppenlaufzeit der Filter gegeben ist.

Je schmalbandiger die Filter ausgelegt werden, desto höher ist deren Gruppenlaufzeit. Der Phasenfehler, der durch diese Verzögerung der Steuerspannung gegenüber der ZF-Signalbewegung entsteht, wächst mit der Schnelligkeit der ZF-Signal- änderung und würde bei einfachen Mitlauffilteranordnungen (auch bei PLL- oder Synchronverfahren) dazu führen, daß im höheren NF-Frequenzbereich die Filter nicht synchron mit dem momentanen ZF-Signal mitlaufen, sondern asynchron gegenlaufen würden. Der Umkehrpunkt zwischen Mit- und Gegenlaufbereich läge bei der hier verwendeten Gesamtbandbreite von ca. 20 kHz etwa bei 6 kHz.

Ein korrektes Mitlaufen der Anordnung über den gesamten NF-Bereich wird bevorzugt durch folgende Maßnahmen erreicht:
1. Der Frequenzgang für die Steuerspannung der schmalbandigen Einzelfilter sieht eine leichte Höhenangebung vor. Die durch diese Hochpaßcharakteristik entstehende Phasenvoreilung kompensiert zum Teil die durch die Gruppenlaufzeit der Filter bedingte Phasennacheilung der Steuerspannung.
2. Die Addition der Durchlaßkurven des Bandfilters mit der der Einzelfilter führt zu einer Filtercharakteristik, bei welcher die Filterflanken im Resonanzbereich die übliche LC-Schwingkreischarakteristik aufweisen; nach einem Abfall von ca. 8 dB jedoch in einen flacher abfallenden, dem Bandfilter entsprechenden Verlauf übergehen. Eine solche Charakteristik erhöht die Nachführbarkeit im höheren NF-Berich gegenüber einer Filtercharakteristik, welche eine durchgehende Einzelkreischarakteristik aufweist.
3. Der noch verbleibende Phasenfehler bewirkt im höheren NF-Bereich eine Relativbewegung zwischen dem ZF-Signal und den Filtern. Hierdurch entsteht eine Phasenstörmodulation. Diese wird dadurch beseitigt, daß das ZF-Signal über einen Phasenmodulator eine zu dieser Störmodulation gegenphasige Modulation erhält, so daß die Störmodulation und damit auch der Phasenfehler zwischen dem momentanen ZF-Signal und der Bewegung der Filter weitgehend kompensiert wird.

Die Steuerung der Resonanzlage der Filteranordnung erfolgt also im wesentlichen in Abhängigkeit des momentanen ZF-Signals, also unabhängig von anderen Empfangsverhältnissen wie Höhe des Nutz- oder des Nachbarkanalpegels. Die Durchlaßcharakteristik jedoch ist von diesen Größen abhängig, nicht hingegen von der Lage des momentanen ZF-Signals.

Je stärker der Multipathempfang (im wesentlichen Nachbarkanalempfang) wird, je höher also die Selektionsanforderung wird, desto schmalbandiger wird die Durchlaßcharakteristik der in ihrer Resonanzlage gesteuerten Filter.

Für die Erfindung wesentlich ist, daß gerade mit dem geregelten ZF-Signal ein Signal zur Verfügung steht, welches trotz integrierend wirkendem Regler in seinen Amplitudenschwankungen außer dem Nutzsignal die entscheidenden Informationen enhält, die zum Erzielen von Schaltsignalen zur Veränderung des Verarbeitungskanals zwecks Erlangung des möglichst ungestörten Nutzsignals bilden können. Diese Informationsanteile werden durch die auszulösenden Umschaltungen relativ wenig verändert, so daß sie einen neutralen Meßstab bei der Signalverarbeitung darstellen.

Gemäß vorteilhaften Weiterbildungen werden die für bestimmte Empfangsbeeinträchtigungen kennzeichnenden Signale erfaßt und durch Signalverknüpfungen Ausgangssignale abgeleitet, welche einzelne - oder eine Reihe von - Gegenmaßnahmen bei der Verarbeitung im Nachrichtenkanal einleiten, die der jeweiligen Empfangsbeeinträchtigung optimal entgegenwirken.

Die Grenze des Regeleinsatzes bei der Regelung des ZF-Signals wird bei einer vorteilhaften Weiterbildung der Erfindung als Kriterium für eine kritische Grenze der Empfangsfeldstärke genutzt.

Obgleich auch mit der Filternachführung Amplitudeneinschnürungen verbunden sind und auch das FM-Nutzsignal zu einer Amplitudenmodulation führt, beeinflussen sich die beiden die Verarbeitungscharakteristik bestimmenden Informationsanteile - für die Filternachführung einerseits und die Anpassung der Form der Filterung andererseits - kaum gegenseitig, so daß ein insgesamt effektives Systemverhalten ohne unübersichtliche gegenseitige Einwirkungen von Regel- bzw. Steuergrößen erhalten wird.

Besonders vorteilhaft ist weiterhin, daß die die Verarbeitungscharakteristik bestimmenden Signale im wesentlichen einheitlich aus Amplitudenschwankungen der ZF abgeleitet werden. So wird das Verhältnis von Nutz- zu Nachbarkanalsender durch die Amplitudenmodulation auf der ZF, die durch die Interferenz zwischen Nutz- und NachbarkanalSender auftritt, erkannt, wobei die ZF auf einen festen Spannungswert geregelt ist.

Hierbei wird in günstiger Weise das Verhältnis der Signalpegel beider Sender erkannt. Steigt die Nutzfeldstärke bei konstanter Nachbarkanalfeldstärke auf den doppelten Wert an, so würde sich bei ungeregelter ZF deren Pegel verdoppeln, die Amplitudenmodulation durch die Interferenz jedoch bleibt konstant. Bei geregelter Amplitude hingegen bleibt die Amplitude konstant und die Amplitudenmodulation geht entsprechend dem Verhältnis von Nutz- zu Nachbarkanalfeldstärke auf den halben Wert zurück.

Auf diese Weise lassen sich Nachbarkanal-Störungen und alle die Amplitudenmodulation beeinflussenden Effekte einheitlich innerhalb der Regelschleife nachweisen.

So werden wie bei Nachbarkanalstörungen auch Reflexionsstörungen an der durch sie hervorgerufenen Amplitudenmodulation der ZF erkannt. Durch die Überlagerung mehrerer Wellen unterschiedlicher Phasenlage entstehen Amplitudeneinschnürungen der ZF, deren Hüllkurve ein breitbandiges NF-Spektrum aufweist. Da auch die Nutzmodulation zu einer leichten Amplitudenmodulation auf der ZF führt, wird für die Reflexionserkennung aus dem Spektrum der ZF-Hüllkurve ein Frequenzbereich herausgefiltert, welcher nur zu einem geringen Anteil im MPX-Signal enthalten ist. Dieser liegt zwischen 20 und 30 kHz. Die Ausgangsspannung der hierzu verwendeten Filterstufe (bedämpfter LC-Schwingkreis) wird einem Schwellwertschalter zugeführt, der ein eindeutiges Erkennungssignal abgibt.

Der Erfindung liegt weiterhin die Erkenntnis zugrunde, daß für ein in sich ausgewogenes FM-Empfangssystem jegliche durch eine Empfangsstörung hervorgerufene Beeinträchtigung des Audiosignals so weit herabgemindert sein muß, daß sie sich im hörbaren NF-Signal in jedem Fall weniger bemerkbar macht als es ihrer Einwirkung auf das HF-Signal entspricht. Dieser Philosophie entspricht eine stets optimale Anpassung des ZF- und NF- Übertragungskanals an die Eigenschaften des gestörten HF-Signals, um auf diese Weise dessen ungestörten Anteile möglichst weitgehend nutzbar zu machen bzw. die Auswirkungen von unvermeidlichen auf das NF-Signal durchdringenden Störbeeinflussungen möglichst herabzumindern.

Bevor auf die verschiedenen Durchlaßkurven eingegangen wird, sei kurz das Grundprinzip der Erkennungen erläutert:
Nachbarkanalerkennung

Nachbarkanalstörungen werden an der Interferenz erkannt, die ein Nachbarsender mit dem Nutzsignal bildet. Hierzu wird das ZF-Signal gleichgerichtet und über einen Hochpaß mit anschließendem Verstärker Schwellwertschaltern zugeführt, an deren Ausgängen das Erkennungssignal vorliegt. Erkannt werden Nachbarkanalstörungen in mehreren Intensitätsstufen.

Wichtig für die Erkennung des Nachbarkanalempfangs ist, daß nicht etwa der Absolutwert des Nachbarkanalsenders, sondern das Verhältnis von Nutz- zu Nachbarkanalfeldstärke erkannt wird, denn nur dieses ist für Nachbarkanalstörungen entscheidend.

Das Verhältnis von Nutz- zu Nachbarkanalsender wird durch die Amplitudenmodulation auf der ZF, die durch die Interferenz zwischen Nutz- und Nachbarkanalsender auftritt, erkannt, wobei die ZF auf einen festen Spannungswert geregelt ist.

Hierbei wird in vorteilhafter Weise das Verhältnis der Signalpegel beider Sender erkannt. Steigt etwa die Nutzfeldstärke bei konstanter Nachbarkanalfeldstärke auf den doppelten Wert an, so würde sich bei ungeregelter ZF deren Pegel verdoppeln, die Amplitudenmodulation durch die Interferenz jedoch bliebe konstant. Bei geregelter Amplitude hingegen bleibt die Amplitude konstant und die Amplitudenmodulation geht entsprechend dem Verhältnis von Nutz- zu Nachbarkanalfeldstärke auf den halben Wert zurück.

Im einzelnen erfolgt die Nachbarkanalerkennung bevorzugt wie folgt: Die ZF wird zunächst amplitudenmoduliert, anschließend wird über einen zweipoligen Hochpaß mit einer Grenzfrequenz von ca. 40 kHz das Interferenzsignal von den übrigen auf der ZF als AM liegenden Signalen getrennt. Das so herausgefilterte Interferenzsignal wird verstärkt (ca. 40 dB) und anschließend wird über dieses Signal die Hüllkurve gebildet. Über einen nachfolgenden Tiefpass zur Glättung etwaiger Rauschspitzen wird das Signal parallel mehreren Komparatoren zugeleitet, die Erkennungssignale abgeben, sobald das Eingangssignal ihren vorgegebenen Referenzpegel überschreitet.

Erkannt wird mit dieser Anordnung der Nachbarkanalempfang in mehreren Intensitätsstufen. Da nach Erreichen der ersten Intensitätsstufe die Filtercharakteristik schmalbandiger geschaltet wird, geht die Nachbarkanalinformation leicht zurück. Dieser Rückgang der Eingangsgröße des Komparators wird durch entsprechendes Anheben des Referenzpegels also durch eine entsprechende Hysterese kompensiert.

### Feldstärkeerkennung

Das ZF-Signal wird über eine Integralregelung auf einen vorbestimmten, konstanten Spannungswert geregelt. Das Ausgangssignal des Integrators ist hierbei ein Maß für den Pegel der ZF. Dieses Ausgangssignal wird mehreren, vorzugsweise zwei, Komparatoren zugeführt, an deren Referenzeingängen diejenigen Spannungspegel anstehen, welche den Regelspannungswerten bei denjenigen Antennespannungen entsprechen, bei denen geschaltet werden soll. Die Ausgangssignale der Komparatoren (logische High-/Low-Signale) geben den jeweiligen Feldstärkebereich an, in dem die aktuelle Feldstärke gelegen ist.

### Umschaltung der Selektionskurven

Es werden bevorzugt verschiedene Selektionskurven unterschieden, die jeweils durch die momentane Empfangsituation bestimmt werden. In der Reihenfolge der Selektivität wird die Filteranordnung bevorzugt nach folgendem Schema wie geschaltet, wobei auch eine geänderte Zuordnung durch Weglassen oder Umordnen einiger Signalverknüpfungsbedingungen im Verarbeitungszug Signalaufnahmeteil, Signalaufbereitungsteil und Signalausgabeteil den Bereich der Erfindung nicht verläßt.

NKo:
- Bandfilter bedämpft
- nur Bandfilterkanal durchgeschaltet

NK₁:
- Bandfilter leicht bedämpft
- nur Bandfilterkanal wirksam

NK₂:
- Bandfilter entdämpft ("entdämpft" heißt hier, daß die zum Kreis zuschaltbaren Bedämpfungswiderstände nicht zugeschaltet sind)
- Einzelkreiskanal bedämpft
- beide Kanäle durchgeschaltet

Schwaches Signal (kleiner Empfangspegel):
- Bandfilter entdämpft
- Einzelkreiskanal entdämpft
- beide Kanäle durchgeschaltet (Monoempfang)

N K₃ :
- Einzelkreis entdämpft
- nur Einzelkreis durchgeschaltet (Monoempfang)

(Die Bezeichnungen NKₒ bis NK₁ entsprechen dabei einer zunehmenden Intensität von Nachbarkanalstörungen.

Das Umschalten zwischen den einzelnen Filterzuständen erfolgt ohne jeglichen Störeinfluß (z.B. Knackgeräusche). Auch ergeben sich hierbei keinerlei störende Übergangsphasen, denn es wird bereits vor Erreichen eines Störgrenzpegels auf den nächst selektiveren Filterzustand geschaltet.

Neben der Nachbarkanal- und Feldstärkeerkennung, welche die Durchlaßcharakteristik der Filter steuern, ist eine zweistufige Reflexionserkennung vorgesehen, welche die Niederfrequenz beeinflußt.

### Reflexionserkennung

Wie bei Nachbarkanalstörungen werden auch Reflexionsstörungen an der durch sie hervorgerufenen Amplitudenmodulation der ZF erkannt. Durch die Überlagerung mehrerer Wellen unterschiedlicher Phasenlage entstehen Amplitudeneinschnürungen der ZF, deren Hüllkurve ein breitbandiges NF-Spektrum aufweist. Da auch die Nutzmodulation zu einer leichten Amplitudenmodulation auf der ZF führt, wird für die Reflexionserkennung aus dem Spektrum der ZF-Hüllkurve ein Frequenzbereich herausgefiltert, welcher nur zu einem geringen Anteil im MPX-Signal enthalten ist. Dieser liegt zwischen 20 und 30 kHz. Die Ausgangsspannung der hierzu verwendeten Filterstufe (bedämpfter LC-Schwingkreis) wird einem Schwellwertschalter zugeführt, der ein eindeutiges Erkennungssignal abgibt. Reflexionsstörungen werden in zwei Intensitätsstufen erkannt; bei Stufe 1 wird lediglich von Stereobetrieb auf Mono umgeschaltet, bei Stufe 2 wird ein Muting der NF durchgeführt.

### Reflexionserkennung und Mutingschaltung

Sowohl Reflexionen als auch Rauschen führen zu Amplitudeneinschnürungen des ZF-Signals. Bei Reflexionen entstehen diese Einschnürungen durch die Überlagerung der direkt empfangenen mit reflektierten Wellen, bei Rauschen durch die Überlagerung des Empfangssignals mit Rauschkomponenten. Der Mittelwert des ZF-Signals nimmt mit zunehmenden Rauschen bis hin zum Leerlaufrauschen ab. Er ist also im Rauschbereich stets gering. Bei Reflexionen kann der Mittelwert jedoch hohe Werte aufweisen wie sie etwa bei Stereobetrieb ohne Signal vorliegen. Die Aussage über die Amplitudeneinschnürungen der ZF wird nun mit der Aussage über die Höhe des Mittelwertes der ZF in folgender Weise verknüpft:
- ist der Mittelwert der ZF gering kann die Ursache für die Einschnürungen der ZF entweder Rauschen oder Reflexionsempfang sein. Die möglichen Ursachen führen zu Störeindrücken, für welche die gleiche Schaltmaßnahme erforderlich ist: Herabsetzen der Lautstärke (Muten) des NF-Signals.
- ist der Mittelwert der ZF hoch, so kann die Ursache für Amplituden-Einschnürungen nur Reflexionsempfang sein. Da der Störeinsatz bei Stereoempfang vor dem Monoempfang liegt, wird zunächst von Stereoempfang auf Monoempfang umgeschaltet und bei tiefer werdenden Einschnürungen, wenn auch das Mono-Signal gestört wird, wird auch die NF-Lautstärke herabgesetzt.

### Nachbarkanalübernahmeerkennung

In diesem Bereich kommt es zu kurzzeitigen Durchbrüchen des Nachbarsenders, die zu "plop"- artigen Geräuschen führen. Über einen Schwellwertschalter, dem die tiefpaßgefilterte Niederfrequenz zugeführt wird, ergibt sich hierfür eine eindeutige Erkennung.

Als Vorteile der erfindungsgemäßen Anordnung ergeben sich insbesondere:
Ohne Empfänger-Standardwerte (NF-Klirrfaktor, Stereo-Übersprechen) zu beeinflussen, werden alle Empfangsstörungen, deren Ursache durch die natürlichen Grenzen konventioneller Empfänger hinsichtlich Empfangsempfindlichkeit und Selektionsfähigkeit gegeben ist, beseitigt oder reduziert:
   - Kaum im Rauschen wahrnehmbare Sender werden klar empfangen (Empfindlichkeitserhöhung 8 bis 10 dB).
   - Störungen aufgrund kurzfristiger Signalabschwächung (Abschattung, Flatter-Fading etc.) werden stark reduziert.
   - Nachbarkanalstörungen bis zur höchsten Intensität, nämlich der vollständigen Übernahme des Nachbarsenders, werden unterdrückt (Selektionsgewinn ca. 30 dB).
   - Nicht nur Nachbarkanalstörungen sondern auch andere Inbandstörungen wie z.B. Intermodulationsstörungen oder Störungen durch das Eurosignal werden unterdrückt.
   - Stereoempfang ist auch dann noch möglich, wenn bei konventionellen Empfängern bereits gestörter Monoempfang vorliegt.
   - Aufgrund der hohen Störsicherheit könnte die Stereoschwelle um ca. 6 dB gegenüber konventionellen Empfängern zu geringeren Empfangsfeldstärken verschoben werden.
   - Es ergibt sich eine erhöhte Übertragungssicherheit von Zusatzsignalen wie etwa bei dem Radio-Data-System.
   - Störungen durch Weitabreflexionen werden reduziert.

Vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
Figuren 1 und 1 ein Blockschaltbild eines Ausführungsbeispiels des erfindungsgemäßen FM-Empfängers,
Figur 2 eine Wahrheitstabelle als Grundlage der logischen Verknüpfung der für die Empfangsverhältnisse charakteristischen Signale zur Erlangung von Steuersignalen zur Beeinflussung der Empfängercharakteristik,
Figur 3 verschiedene bei unterschiedlichen Empfangszuständen wirksame ZF-Durchlaßkurven,
Figur 4 eine Wahrheitstabelle als Grundlage für die logische Verknüpfung zur Beeinflussung der Nachführcharakteristik der nachführbaren Filter,
Figur 5a die veränderbare Nachführcharakteristik der Einzelkreisfilter,
Figur 5b die veränderbare Nachführcharakteristik für Vor- und Bandfilter
Figur 6 ein Schaltbild eines Teils der Steuerlogik,
Figur 7 eine Einzelheit des Schaltung gemäß Figur 6,

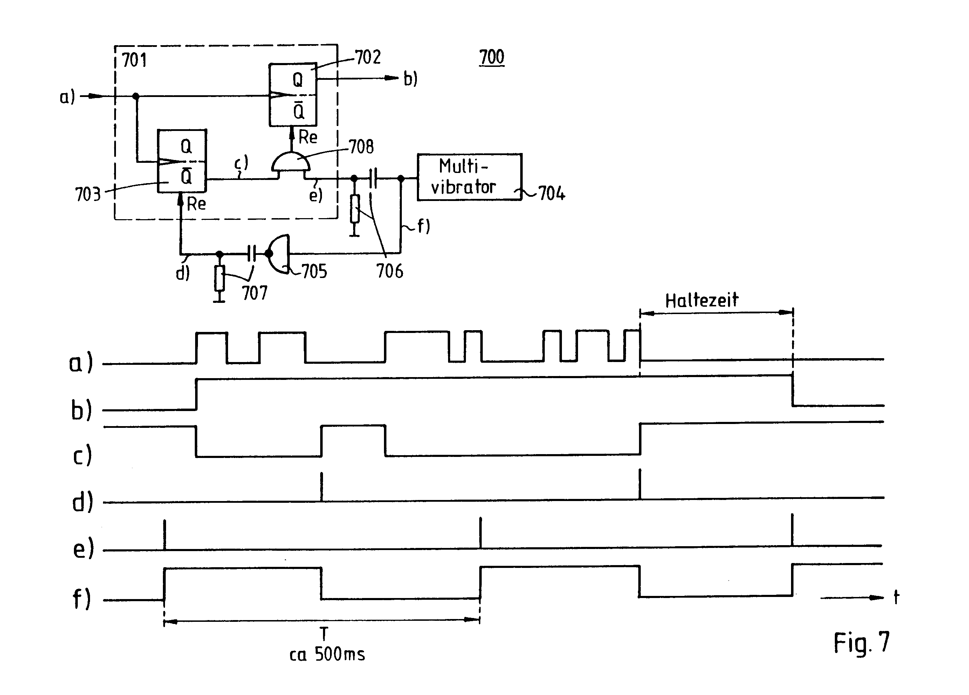

Figuren 7 a bis f Signalverläufe zu Figur 7,

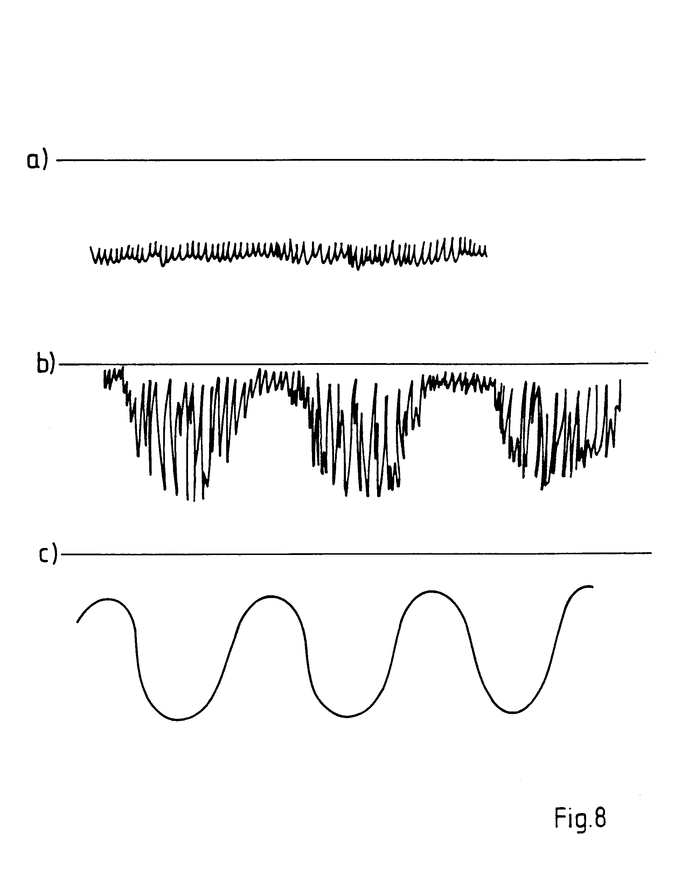

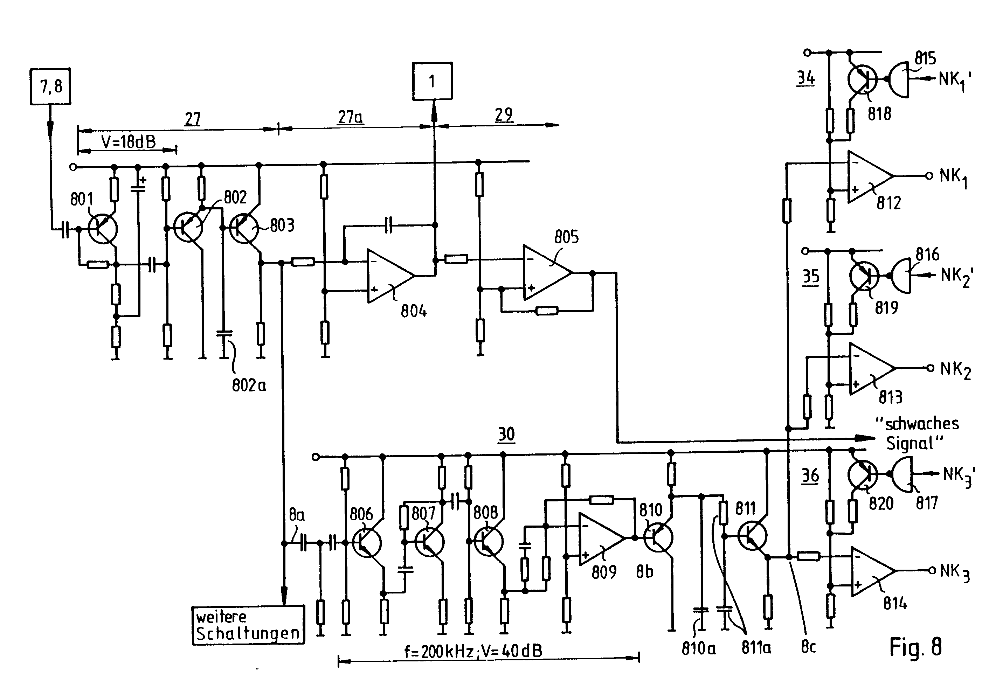

Figur 8 ein Schaltild einer Schaltung zur Nachbarkanalerkennung,
Figuren 8a bis 8c Signalverläufe zu Figur 8,

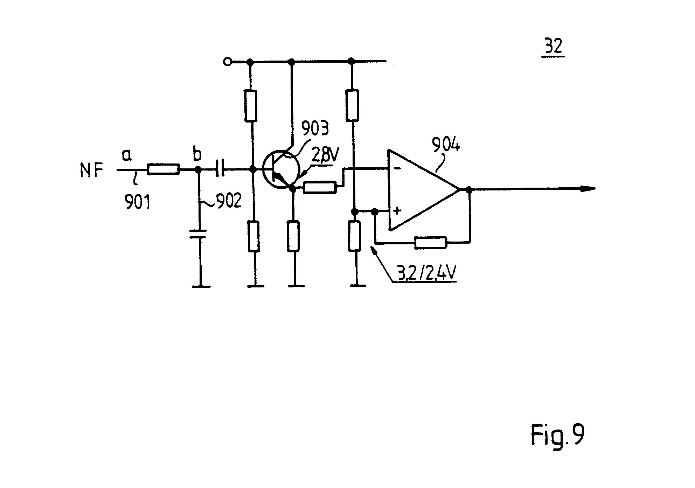

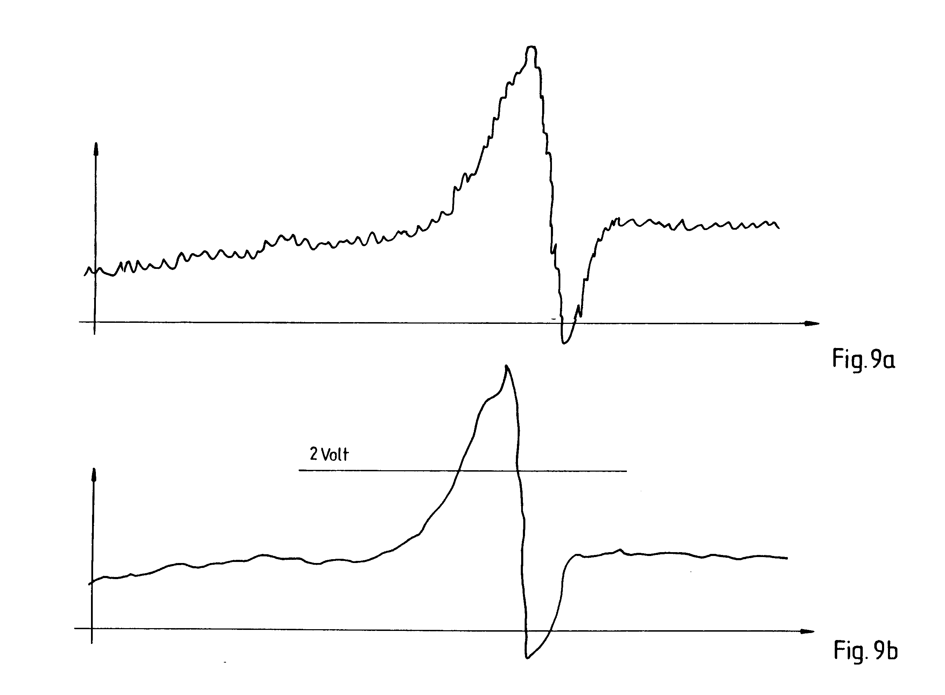

Figur 9 ein Schaltbild einer Schaltung zur Nachbarkanalübernahmeerkennung,
Figuren 9a und 9b Signalverläufe zu Figur 9,

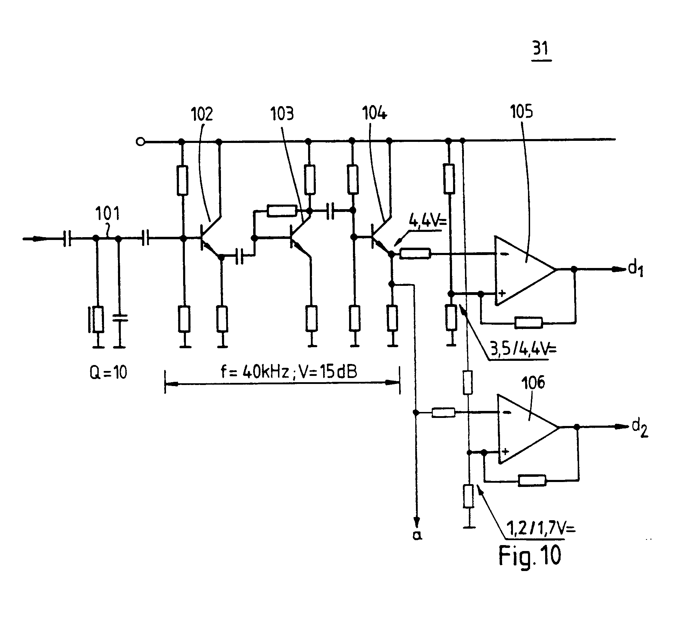

Figur 10 eine Schaltung zur Reflexionserkennung,

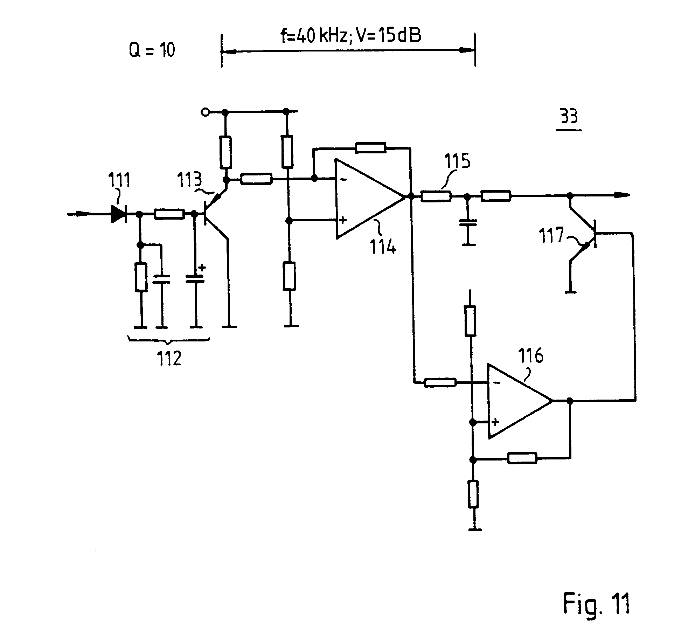

Figur 11 eine Schaltung zur Feldstärkeerkennung für die Mutingfunktion sowie

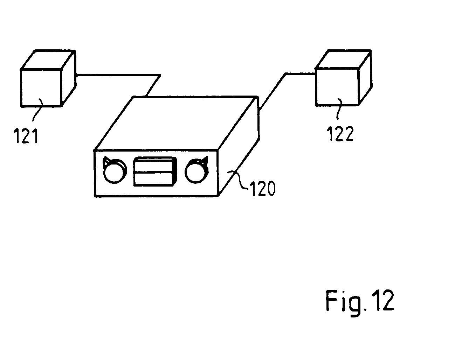

Figur 12 ein Ausführungsbeispiel des erfindungsgemäßen Empfangsteils.

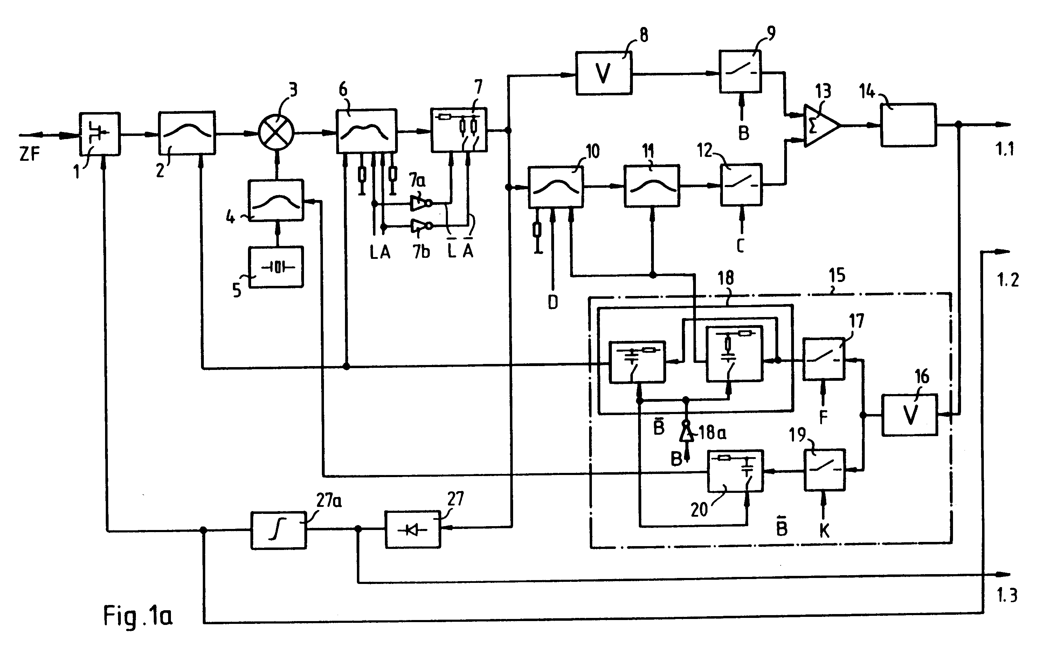

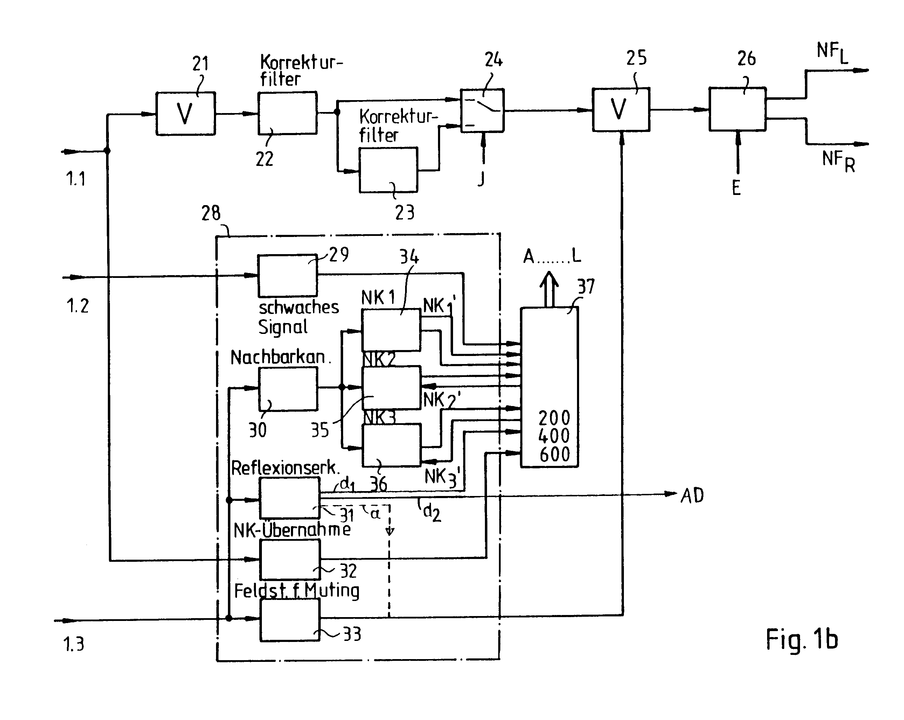

Zunächst soll der grundsätzliche Aufbau der Schaltung betrachtet werden. Der in Figur 1 gezeigte, FM-Stereo-Empfänger ist als Blockschaltbild ohne Vor- und Mischstufe dargestellt, so daß als Eingangssignal der gezeigten Blockschaltung ein normgerechtes ZF-Signal mit einer Frequenz von 10,7 MHz am Eingang ansteht. Bei dem betrachteten sogenannten MPX-Signal ("MPX = Multiplex) handelt es sich um ein übliches analoges FM-Stereo-Rundfunksignal.

Das 10,7 MHz-ZF-Eingangssignal gelangt von einem Eingang (Pfeil) über eine Amplitudenregelstufe 1, die einen FET als steuerbar veränderlichen Widerstand aufweist, zu einem einkreisigen ZF-Vorfilter 2 mit einer Bandbreite im Bereich von 150 kHz.

Dem Filter 2 ist eine Mischstufe 3 nachgeschaltet. Am Ausgang der Mischstufe steht das ZF-Signal im 700 kHz-Bereich zur Verfügung. Die Frequenz eines die Mischstufe 3 über einen Phasenmodulator 4 beeinflussenden Oszillators 5 beträgt somit 10 MHz.

Das Ausgangssignal der Mischstufe 3 gelangt zu einem zweikreisigen Bandfilter 6. Dieses Bandfilter kann mittels zweier an entsprechenden Eingängen anstehenden Steuersignalen L und A jeweils durch Parallelschaltung eines internen Widerstands in zwei Stufen bedämpft werden. Die Widerstände sind in der Zeichnung symbolisch angedeutet und werden den Filterkreisen parallelgeschaltet, um in bekannter Weise eine vergrößerte Filterdämpfung zu erreichen. Auf diese Weise wird also eine erwünschte Abflachung der Durchlaßkurve erzielt. Die Bandbreite des Bandfilters ist mit ca. 90 kHz zur Übertragung des Multiplexsignals geeignet bemessen.

Dem Ausgang des Bandfilters folgt als Schaltung zur Pegelabsenkung eine Abschwächerstufe 7, mit der zwei verschiedene Pegelverminderungen mittels entsprechender Steuersignale Ë und A gezielt anwählbar sind. Diese Signale werden von den Signalen L und A mittels Invertern 7a und 7b abgeleitet.

Die einschaltbaren Pegelverminderungen kompensieren die durch die wahlweise Bedämpfung des Bandfilters erzeugten Pegeländerung, so daß das ZF-Signal am Ausgang der Stufe 7 eine weitgehend konstante Amplitude aufweist. Abweichungen werden durch eine weiter unten zu beschreibende Regelung ausgeglichen, deren Eingangssignal nach dem Ausgang der Stufe 7 - gegebenenfalls nach linearer Verstärkung - abgegriffen wird.

Nach dem Ausgang des Abschwächerstufe 7 teilt sich die weitere Signalverarbeitung auf. Im dem in der Zeichnung oben dargestellten Verarbeitungszweig erfolgt eine geringe Amplitudenverstärkung ohne Beeinflussung des Frequenzgangs.

Am Ausgang des Verstärkers 8 ist eine steuerbare Schaltstufe 9 vorgesehen, mit der auf ein entsprechendes Steuersignal hin der betreffende Signalverarbeitungszweig abgeschaltet werden kann. Am Ausgang des Verstärkers wird ein Signal abgegriffen, das verschiedene weiter unten beschriebenen Stufen zugeführt wird. Dieses Signal ist von der schaltstufe 9 nicht betroffen.

Im in der Zeichnung unteren Signalverarbeitungszweig gelangt das Signal zum Eingang eines ersten von zwei sehr schmalbandigen, hintereinandergeschalteten Mitlauffiltern 10 und 11. "Sehr schmalbandig" heißt hier ungefähr 20 kHz. Das erste dieser Filter ist auf ein entsprechendes Steuersignal hin ebenfalls durch Parallelschaltung eines entsprechend dimensionierten Widerstands bedämpfbar. Die Bedämpfung ist in der Zeichnung durch einen Widerstand symbolisch wiedergegeben.

Die (einzeln schaltbaren) Bedämpfungen bewirken sowohl beim Bandfilter 6 als auch bei dem Einzelfilter 10 einen flacheren Verlauf der jeweiligen Durchlaßkurve.

Dem zweiten Einzelfilter 11 ist eine weitere Schaltstufe 12 nachgeschaltet, mit der ebenfalls auf ein Steuersignal hin der betreffende Signalverarbeitungszweig abgeschaltet werden kann.

Die Ausgangsignale der Schaltstufen 9 und 12 werden in einer Addierstufe 13 summiert. Bei der Addierstufe 13 handelt es sich um einen Summierverstärker, welcher das gefilterte ZF-Signal auf einen Pegel heraufsetzt, wie er für die anschließende Demodulation im Demodulator 14 benötigt wird.

Das Ausgangssignal des Verstärkers 16 gelangt parallel über zwei Schalter 17 und 19, die mit Steuersignalen F bzw. K aktiviert werden, auf zwei Steuernetzwerke 18 und 20. Vom Steuernetzwerk 18 werden die Steuersignale für die Vor-, Band-und Einzelfilter an geeigneter Stelle abgenommen. Über das Steuernetzwerk 20 wird das Steuersignal für den Phasenmodulator erhalten.

Von dem demodulierten Signal wird die Nachführspannung für die vorangehenden Filterstufen abgeleitet und dazu zunächst einem Steuernetzwerk 15 (gestrichelt umrandet) zugeführt. Das Steuernetzwerk enthält - folgend auf einen Eingangsverstärker 16 - in einem ersten Zweig einen steuerbaren Schalter 17 und ein in seiner Filtercharakteristik umschaltbares Netzwerk 18, von dem die Nachführspannungen für das Vorfilter 2 und das Bandfilter 6 einerseits und die beiden Einzelfilter 10 und 11 andererseits abgeleitet werden.

Das demodulierte, mit "NF" bezeichnete Signal am Ausgang des Demodulators 14 wird mittels einer Verstärkerstufe 21 leicht im Pegel angehoben und einem ersten Korrekturfilter 22 zugeführt. Diesem Korrekturfilter folgt ein zweites Korrekturfilter 23, das mittels eines durch ein externes Signal steuerbaren Schalters 24 wahlweise überbrückbar ist. Mittels der Korrekturfilter 22 und 23 wird das Ausgangssignal einer Pegel- und Phasenkorrektur unterzogen, um die unterschiedlichen Pegel- und Phasenverläufe in den beiden vorangehenden Filterzweigen, entsprechend der jeweils gewählten Verarbeitung, auszugleichen.

Durch das schaltbare Filter 23 wird im Falle des Auftretens der später zu beschreibenden Nachbarkanalstörungen eine leichte Höhenanhebung des NF-Signals bewirkt, um die durch die dann schmalere ZF-Bandbreite bewirkte Höhenabsenkung auszugleichen.

Das so korrigierte NF-Signal, das sämtliche Komponenten des MPX-Signals enthält, wird einer der Korrekturstufe nachgeschalteten steuerbaren Mutingschaltung 25 und anschließend einem Stereodecoder 26 zugeführt, an dessen Ausgang das linke und rechte NF-Signal NF_{L} bzw. NF_{R} erscheinen. Der Stereodecoder ist mittels eines entsprechenden Steuereingangs auf Monobetrieb einstellbar. In diesem Fall sind beide NF-Ausgangssignale identisch.

Die Zwischenfrequenz wird auf einen festen Spannungswert geregelt. Hierzu wird sie einer Reglerschaltung zugeführt, die aus einem Gleichrichter 27 und einem Integrator 27a besteht, an dessen Eingang die Regelabweichung gelangt und dessen Ausgangssignal die Regelspannung darstellt.

Die gleichgerichtete ZF, als Eingangssignal der Regelschaltung, deren Mittelwert innerhalb des Regelbereichs konstant bleibt, dient als Eingangsgröße für die Nachbarkanalerkennung, die Reflexions-und Muteerkennung.

Die Regelspannung am Ausgang des Integrators ist innerhalb des Regelbereichs ein Maß für den Eingangspegel der ZF und damit ein Maß für den Pegel der Nutzfeldstärke. Die Regelspannung wird einer weiteren Erkennungsschaltung zugeführt, aus welcher lediglich die Aussage abgeleitet wird, ob das Eingangssignal ober- bzw. unterhalb eines bestimmten Pegels (z.B. 2 uV Antenneneingangsspannung) liegt.

Das Niederfrequenzsignal ist Eingangsgröße einer weiteren Erkennungsschaltung, aus welcher abgeleitet wird, ob ein Nachbarsender kurzzeitig "durchschlägt". In diesem Störungsbereich der Nachbarkanalübernahme gibt die Erkennungsschaltung ein entsprechendes Signal ab.

Die Eingangsgrößen der in Baugruppe 28 zusammengefaßten Erkennungsschaltungen sind also:
1. die gleichgerichtete ZF für NK- und Reflexionserkennung, sowie für Muting
2. die Regelspannung der ZF für die Erkennung der Größe der Feldstärke,
3. das Niederfrequenz-Signal für die NK-Übernahmeerkennung.

Diese Erkennungsschaltungen sind in der gestrichelt umrahmten Baugruppe 28 zusammengefaßt, deren Ausgangssignale den verschiedendenen Filter- und Schaltstufen als Steuersignale zugeführt werden. Sie erzeugen alle notwendigen Schaltsignale, welche die Filter- und Nachführcharakteristiken sowie weitere Signalverarbeitungskriterien umschalten, um trotz gestörter Empfangsverhältnisse die relativ beste Hörqualität zu gewährleisten. Nicht in der Baugruppe 28 enthalten sind die bereits zuvor beschriebenen Schaltungen zur Erzeugung der Nachführspannungen.

Aus der Hüllkurve als Ausgangssignal des Reglers 27, 27a leiten sich damit die Eingangssignale nahezu sämtlicher Erkennungsschaltungen durch die in der Baugruppe 28 enthaltenen Schaltungen zur Feldstärkeerkennung 29, zur Nachbarkanalerkennung 30, zur Reflexionserkennung 31, zur Nachbarkanalübernahmeerkennung 32 und zur Feldstärkeerkennung für Muting 33. Die letztgenannte Schaltung dient zur Ansteuerung der Muting-Schaltung 25 und gibt ein Ausgangssignal ab, wenn mit der Wiedergabelautstärke wegen Aufrauschens zurückgegangen werden sollte. Sie erkennt, wann das Nutzsignal im Rauschen untergeht, wann die ZF also zu klein wird, um ein brauchbares NF-Signal zu liefern. Diese Schaltung entspricht den bekannten Muting-Schaltungen, wie sie beispielsweise benutzt werden, um bei der Abstimmung Rauschen zwischen der Scharfabstimmung einzelner Sender zu unterdrücken.

Bei einer in Figur 1 nach der Schaltung zur Reflexionserkennung 31 durch eine gestrischelte Verbindung dargestellte Variante wird das Mute-Signal statt durch die getrennte Schaltung 33 ebenfalls durch die Schaltung 31 (Ausgang a) ermittelt. Weiterhin wird durch diese Schaltung auch ein Signal zur Antennenumschaltung bei vorgesehenem Antennen-Diversity erzeugt (Ausgang d2). Die Einzelheiten dazu sind anhand von Figur 10 beschrieben.

Der Schaltung zur Nachbarkanalerkennung 30 sind noch drei Diskriminatorschaltungen 34 bis 36 nachgeschaltet, welche einzelne Stufen der Intensität der Nachbarkanalstörungen unterscheiden, wobei die Schaltung 34 der schwächsten und die Schaltung 36 der stärksten Störintensität zugeordnet ist.

Die Ausgangssignale dieser Erkennungsschaltungen gelangen zu einer nachfolgenden Auswertungsschaltung 37, welche in logischer Verknüpfung und in Abhängigkeit der Ausgansignale der vorangehenden Schaltungen die Signalverarbeitung steuert. In Abhängigkeit der gefundenen Empfangsbedingungen werden Filterdämpfungen, Signalverarbeitungswege und damit die Durchlaßcharakteristiken geschaltet. Es wird die Gesamtfiltercharakteristik gesteuert, in dem die Bedämpfung aufgeschaltet oder weggenommen wird und nun wahlweise in Abhängigkeit vom Ergebnis der logischen Verknüpfung entweder nur ein Verarbeitungskanal durchgeschaltet wird oder beide überlagert oder auch nur der andere Verarbeitungskanal durchgeschaltet wird.

Das erfolgt zunächst unabhängig von der eigentlichen Nachführsteuerung, da die Filter in ihrer Resonanzlage über das entsprechende Steuernetzwerk 15 ständig beeinflußt werden. Zusätzlich werden aber auch noch am Ausgang der Auswertungsschaltung Signale gewonnen, welche die Nachführcharakteristik beeinflussen, um diese optimal den Empfangsbedingungen anzupassen.

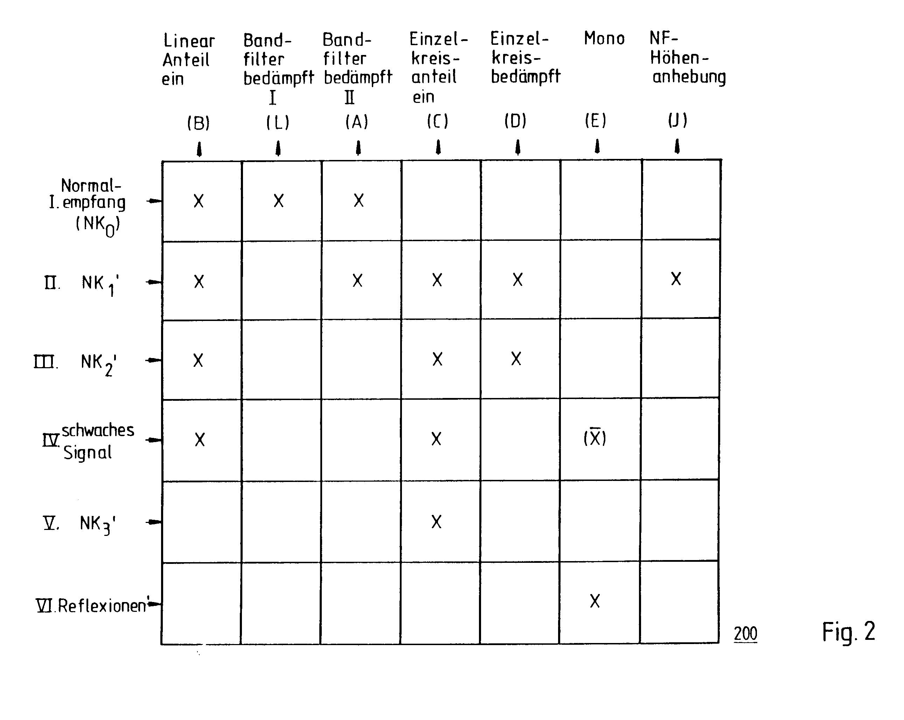

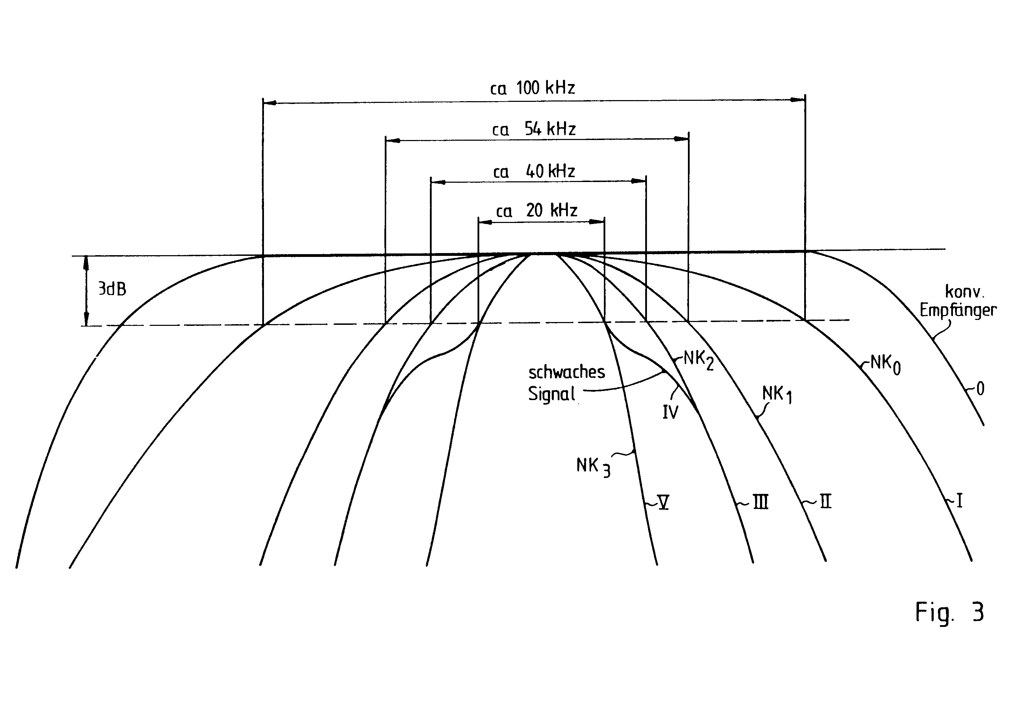

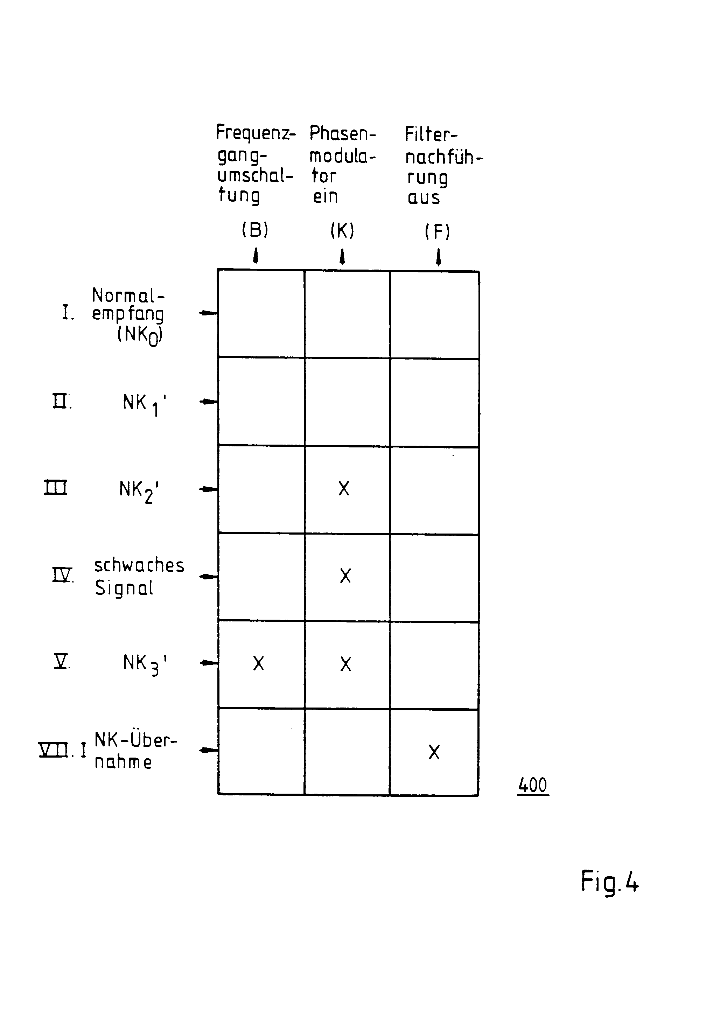

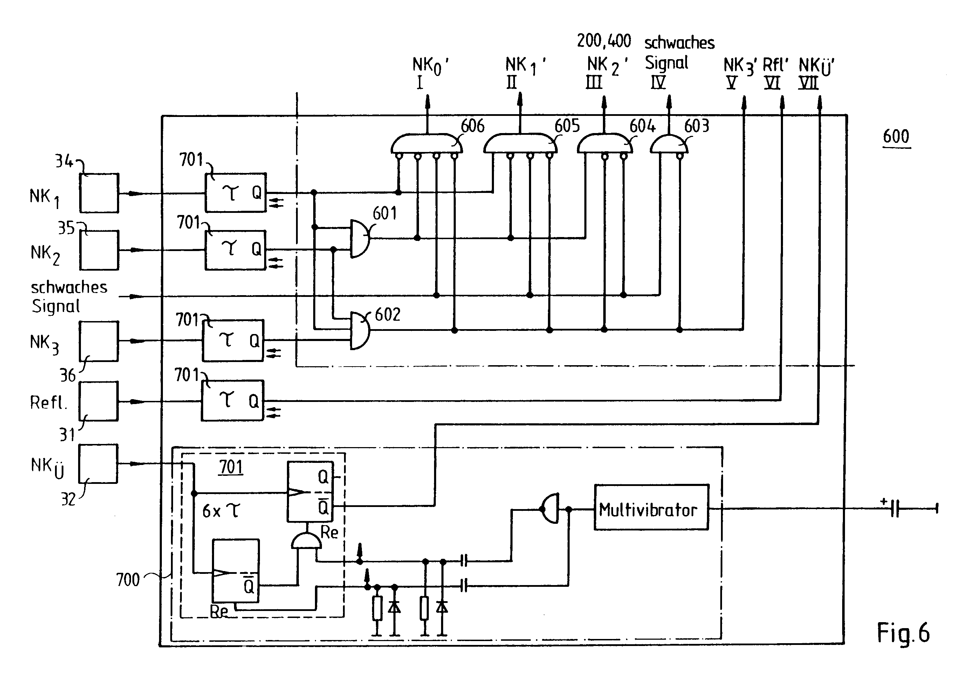

Die verschiedenen logischen Verknüpfungen der Eingangssignale gemaß Block 37 ergeben sich aus der eine logische Verknüpfungsbaugruppe 200 repräsentierenden Wahrheitstabelle nach Figur 2. Die an den verschiedenen Steuermöglichkeiten resultierenden Durchlaßkurven sind jeweils in Figur 3 wiedergegeben. Der Signalerkennungsteil wird durch die Schaltungen gemäß den Blöcken 29 bis 33 repräsentiert. Der Signalaufbereitungsteil umfaßt die Amlitudendiskriminatoren (Schwellwertstufen) der vorstehend genannten Schaltungen und mindestens die Zeitglieder 701 der Schaltung gemäß Figur 6 umfaßt, die weiter unten näher beschrieben wird. Der die Zuordnung zwischen den für Empfangszustände maßgeblichen Größen und den der Steuereingängen der Stufen des Signalverarbeitungsteils herstellende Verknüpfungsschaltung wird durch die Logikteile 200, 400 gemäß Figuren 2 und 4 gebildet.

Nach Erkennen der jeweiligen Empfangssituation wird das Übertragungsverhalten entsprechend umgeschaltet.

Bei Eingangsfeldstärken etwa oberhalb des Empfindlichkeitsgrenzbereiches konventioneller Empfänger und bei einem relativ geringen Verhältnis von NK - zu Nutzsender wird auf den Zustand "NKo" geschaltet. Hier wird ausschließlich der linear verstärkte Anteil (Stufen 8 und 9) des Ausgangssignals des bedämpften Bandfilters 7 (Schaltsignale L und A bewirken die Bedämpfung des Bandfilters 7) auf den Demodulator geschaltet. Durch das Schaltsignal B ist der Schalter 9 geschlossen. Bezüglich der Dämpfung ist die erste Stufe (Schaltsignale L und A auch an Pegelabsenkstufe 7) wirksam. Das Verhalten der Einzelkreisfilter 10 und 11 ist ohne Belang.

Die Gesamtfilterbandbreite bei NKo beträgt etwa 130 kHz.

Die breiteste Durchlaßkurve (I in Figur 3) bei dem erfindungsgemäßen Empfänger ist wegen der Verwendung von Mitlauffiltern noch recht schmal gegenüber der Durchlaßkurve von mit üblichen Filter bestückten Empfängern (in Figur 3 mit "0" bezeichnet), aber relativ breit im Vergleich zu den nachfolgend zu beschreibenden bei starken Nachbarkanalstörungen einzuschaltenden Bandbreiten.

Bei diesem Betrieb ergibt bereits eine erhebliche Selektionssteigerung im Vergleich zu feste Filter aufweisenden Empfängern.

Erhöht sich das Verhältnis von Nachbarkanalzu Nutzfeldstärke, so wird auf "NK, geschaltet. Dieser Zustand führt zur Kurve 11 in Figur 3. Das entsprechende diesen Funktionszustand auslösende Steuersignal wird von der Stufe 34 abgegeben.

Bei NK₁ ist das Bandfilter 6 schwächer bedämpft (Schaltsignal A). Die Bandbreite der Durchlaßkurve beträgt ca. 54 kHz, wie aus Figur 3 ersichtlich ist.

Bei sich verstärkender Nachbarkanalbeeinträchtigung wird die Stufe NK2 wirksam, wobei der entsprechende Schaltzustand durch das Ausgangssignal der Baugruppe 35 in Figur 1 ausgelöst wird. Wie aus der Tabelle gemäß Figur 2 ersichtlich ist, bleibt damit das erste (Band-)Filter 6 unbedämpft, der zweite Kanal wird, bedämpft durch das Steuersignal, eingeschaltet.

Es sind also noch die Signalkanäle wirksam. Es ergibt sich die mit 111 bezeichnete Durchlaßkurve gemäß Figur 3. Die ZF-Bandbreite beträgt noch 40 kHz. Während bei NKO und NK1 Vollstereo vorliegt, wird bei NK2 die Stereobasisbreite reduziert.

Die nächste Schaltstufe IV wird erreicht, wenn die Empfangsfeldstärke einen Mindestpegel, der bei etwa 2 uV liegt, unterschreitet, was durch das entsprechende Ausgangssignal der Schaltung zur Feldstärkeerkennung 29 mitgeteilt wird.

Es führt zu folgendem Zustand: das Bandfilter 6 wird entdämpft (Schaltsignale L und A aus), beide Kanäle sind wirksam (Schalter 9 und 12 über Schaltsignale B und C ein), das Einzelfilter 10 ist entdämpft (Bedämpfungssignal D aus). Die resultierende Durchlaßkurve entspricht der Kurve IV in Figur 3. Es ist ersichtlich, daß diese Kurve im Resonanzbereich die gewohnte LC-Schwingkreis-Charakteristik aufweist und nach einem Abfall von ca 8 dB in die Bandfilter-Kurve NK₂_{(III)} übergeht. Die "Schultern" im Durchlaßbereich führen zu einer verbesserten Nachführbarkeit, so daß auch bei sehr schwachen Empfangssignalen, die mit einem konventionellen Empfänger kaum im Rauschen wahrnehmbar sind, ein guter Empfang vorliegt.

Ein die Selektionsfähigkeit noch weiter steigernder Empfangszustand wird bei extrem starken Nachbarkanalstörungen wirksam. Er ist mit NK₃ bezeichnet, was durch ein entsprechendes Ausgangssignal der Stufe 36 in Figur 1 angezeigt wird.

Ein mit einer Nachbarkanalstörung der Klasse 3 (NK3) beeinträchtigtes Empfangssignal weist extrem starke NK-Störungen, bis hin zur völligen Übernahme des Nachbarsenders, auf. Beim erfindungsgemäßen System zieht sich die Durchlaßkurve der Filteranordnung noch weiter zusammen (Kurve V in Figur 3) und wird so schmalbandig in der Signalverarbeitung, daß auch die stark beeinträchtigende Nachbarkanalstörung ausgeschaltet wird. Dazu wird der schmalbandige Kanal allein ohne Bedämpfung betrieben (Schaltsignale B und D aus, Schaltsignal C ein). Die 3-dB-Bandbreite beträgt ca. 18 kHz.

Es steht damit nur noch die schmalste Bandbreite überhaupt zur Verfügung; der Betriebszustand ist mono. Durch Filter- und Oszillatorsteuerspannungen, die auf diesen Zustand der höchsten Selektivität optimiert sind, wird eine Übertragung erreicht, die in ihrer Qualität kaum beeinflußt ist.

Eine in dieser Weise realisierte Filterdurchlaßcharakteristik kann, ohne vom Erfindungsgedanken abzuweisen, auch auf andere Weise, z.B. mittels digitaler Filter verwirklicht werden.

Als weitere von den Gütekriterien des empfangenen Signals beeinflußte Größe ist in der Tabelle gemäß Figur 2 noch unter Vl. die Erkennung von Reflexionen angeführt. Während bei den im Vorangehenden dargestellten Kriterien für die Empfangsqualität stets das später beschriebene Signal eine Verschlechterung darstellte, welche gegenüber den vorher beschriebenen "Priorität" besitzt, also diesen in der Verarbeitung vorgeht und die nachrangigen Signale "überfährt" (vgl. die Beschreibung anhand Figur 6 weiter unten), wird die Erkennung von Reflexionen bei allen Empfangsbedingungen wirksam. Bei der Erkennung von Reflexionen durch die Schaltung 31 erfolgt mittels des Schaltsignals E eine Zurückschaltung des Stereo-Decoders in den Mono-Betrieb. Gemäß der in Figur 1 gestrichelt dargestellten Variante, bei der das Signal für Zurückschaltung in den Mono-Betrieb mittels der Schaltung für die Reflexionserkennung zusammen mit dem Mute-Signal, über charakteristische Einschnürungen der ZF-erkannt wird, erfolgt eine Zurückschaltung beim Erkennen von Reflexionen (IV.) bei nicht gleichzeitig vorhandenem Kennsignal "Schwaches Signal" (IV.), wenn also die Einschnürungen auf Reflexionen, nicht aber auf Rauschen hindeuten.

Während in Figur 2 eine Wahrheitstabelle für die Verformung der Durchlaßkurve in Abhängigkeit von die Empfangsbedingungen charakteristischen Größen angegeben war, ist in Figur 4 als Baugruppe 400 in tabellenartiger Übersicht eine Wahrheitstabelle für die Nachführcharakteristik der nachführbaren Filter wiedergegeben. Die für das empfangene Signal charakteristischen Größen I bis V entsprechen der Darstellung gemäß Figur 2. Während die erkannten Reflexionen keinen Einfluß auf die Nachführcharakteristik haben, ist ein zusätzliches Signal VII angeführt, welches bei Erkennung der Übernahme des Nachbarkanals ebenfalls Umschaltungen bezüglich der Nachführung der Filter bewirkt.

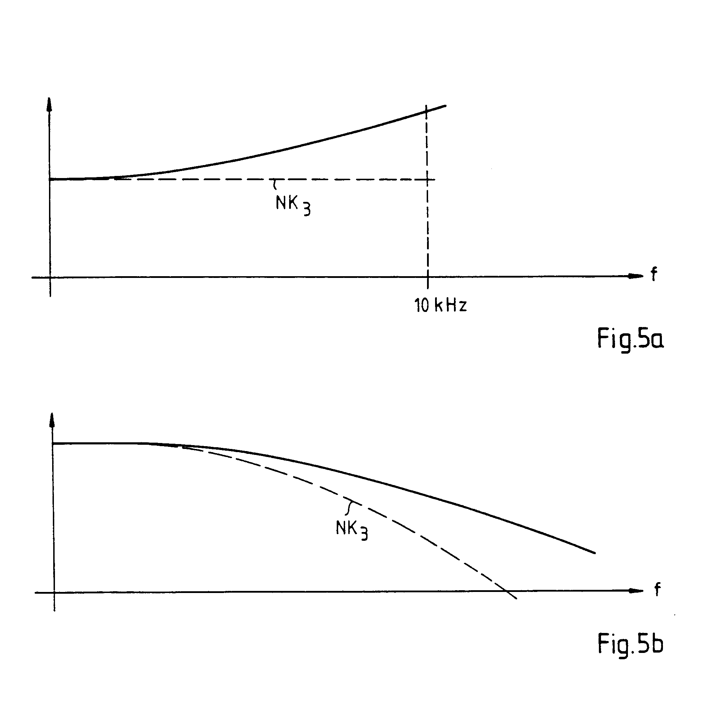

Das Signal B, das aus dem Signal B durch Invertierung hervorgeht, erzeugt eine Frequenzgangumschaltung der Nachführcharakteristik für die Einzelfilter das Vorfilter und das Bandfilter sowie für den Phasenmodulator bei dem Empfangszustand NK₃. Während die Nachführung der Einzelfilter 10 und 11 (Figur 1) aus dem rechten Teil des Blocks 18 im Normalbetrieb mit einer geringfügigen Höhenanhebung bis zu einer Frequenzgrenze von 10 kHz (vgl. Figur 5a - durchgezogener Verlauf) verläuft, wird durch die Umschaltung des Signals 8 ein Tiefpaß zugeschaltet, so daß der Frequenzgang nahezu eben verläuft (gestrichelter Verlauf in Figur 5a). Der Frequenzgang für die Steuerspannung des Vorfilters und des Bandfilters weist bei den Empfangszuständen NKo bis NK₂ eine leichte Tiefpaßcharakteristik auf. Durch die mit dem Signal 8 erzeugte Umschaltung wird die Tiefpaß- charakteristik vergrößert (vgl. Figur 5b - gestrichelter Verlauf).

Zusätzlich zu berücksichtigen ist in Figur 4 der Signalzustand 7 der Nachbarkanalübernahme, welcher einen extremen Störungszustand darstellt in der Weise, daß die Einstrahlung durch den Nachbarkanalsender derart hoch ist, daß kurzfristig eine Modulationsübernahme erfolgt. Weil hierbei die Filternachführung auf den NK-Sender überspringen würde, was in diesem Fall den Störeindruck nur vergrößert, wird die Filternachführung im Falle der Nachbarkanalübernahme durch das Signal F ausgeschaltet. Diese Maßnahme stellt eine Abrundung des erfindungsgemäßen Empfangssystems dar, welches insgesamt zur Verbesserung des Eindrucks beiträgt, den der Benutzer, dem die NF-Signale dargeboten werden, vom System erhält. Die Ausschaltung der Filternachführung erfolgt durch den Schalter 17 in Figur 1.

Die durch die Wahrheitstabellen gemäß Figuren 2 und 4 gebildete Auswertungseinheit 36 in Figur 1 enthält noch eine Schaltung, wie sie in Figur 6 dargestellt ist und zur Verbesserung des Niederfrequenzsignals beiträgt. Während die Wahrheitstabellen gemäß Figuren 2 und 4 entsprechend der gewählten Ausführung durch die Verknüpfung von logischen Gattern oder durch entsprechende Software-Steuerung nach den bekannten Regeln der Schaltung- bzw. Softwaretechnik realisiert werden können, ist in Figur 6 ein Ausführungsbeispiel als Hardware-Lösung wiedergegeben.

Die Signalaufbereitungsschaltung gemäß Figur 6 wird der Auswertungslogik gemäß Figuren 2 bzw. 4 vorangeschaltet, so daß die Ausgangssignale der Baugruppen 31, 32 und 34 bis 36 gemäß Figur 1, zunächst zu der Schaltung gemäß Figur 6 gelangen, während in die in Figur 6 dargestellten Baugruppe 600 ihrerseits zur Ansteuerung der Logikbaugruppen 200 und 400 in der Lage ist, wie sie in den Figuren 2 und 4 schematisch wiedergegeben sind. Die Signalaufbereitungsschaltung gemäß Figur 6 enthält die Zeitschwellenschaltungen, welche zusammen mit den Schwellenschaltungen der Schaltungen 29 bis 33 für eine sichere Steuersignaldiskrimination ohne unter Vermeidung instabiler und undefinierter Schaltzustände sorgen.

Da nach Ansprechen einer Nachbarkanalerkennungsschaltung die Signalverarbeitung schmalbandiger erfolgt, geht das Verhältnis von Nachbarkanal- zu Nutzsender, also die Erkennungsinformation zurück. Dieser Rückgang der Erkennungsinformation wird durch ein entsprechendes Anheben der Ansprechschwelle kompensiert. Der Rückgang der Erkennungsinformation hat auch Auswirkungen auf die Ansprechschwellen der einzelnen Stufen: Bliebe die Filtercharakteristik konstant, so ginge die Erkennungsinformation nicht zurück, und die Ansprechschwellen der einzelnen Stufen lagen gestaffelt untereinander, so daß eine eindeutige Reihenfolge im Ansprechen zwangsläufig gegeben wäre.

Hier jedoch geht die Erkennungsinformation nach Ansprechen einer Stufe zurück, so daß die Ansprechschwellen der einzelnen Stufen nicht deutlich untereinander liegen, sondern alle etwa den gleichen Wert aufweisen. Um dennoch eine eindeutige Reihenfolge im Ansprechen zu erreichen, wird erfindungsgemäß eine Erkennungsstufe durch die vorangehende Stufe gesperrt und erst freigegeben, wenn die vorangehende Stufe angesprochen hat. Für die verschiedenen Erkennungskanäle untereinander wird also durch UND-Gatter dafür gesorgt, daß eine spätere Stufe erst dann anspricht, wenn eine zu einer geringeren Störung gehörige Stufe bereits angesprochen hat. Dem der Stufe NK₂ zugeordneten UND-Gatter 601 wird das Ausgangssignal der Stufe NK₁ zugeführt, so daß letztere angesprochen haben muß, bevor NK₂ anspricht - wenn also diejenigen Filterbedingungen vorliegen, für die die Ansprechschwelle von NK₂ bemessen ist. Entsprechendes gilt für das UND-Gatter 602 und die Ausgangssignale der Stufen NK₁ und NK₂ für das Ansprechen der Stufe NK₃.

Weitere UND-Gatter 603 bis 606 stellen die Prioritäten der Signale in der Reihenfolge NK₃, schwaches Signal, NK₂, NK₁ und NKo hinsichtlich der Weitergabe für die nachfolgende Verarbeitung sicher.

Um zu verhindern, daß die Ausgangssignale der Baugruppe 600 bei kurzzeitigen impulsartigen Signaleinbrüchen bzw. -störungen häufig die Empfangscharakteristik des Systems ändern, wird durch einen Erkennungsimpuls am Ausgang eines Komparators eine retriggerbare Zeitgeberschaltung, z.B. ein monostabiler Multivibrator, gesetzt, dessen Ausgangsspannung die Schaltspannung darstellt. Erst wenn für den Zeitraum der Haltezeit kein Komparatorausgangsimpuls vorliegt, geht die Schaltspannung zurück. Durch diese Maßnahme werden zahlreiche aufeinanderfolgende Einzelimpulse am Ausgang des Komparators zu einer durchgehenden Schaltspannung verbunden.

Um insbesondere bei Realisierung der Schaltung in integrierter Bauform mittels analoger Schaltungstechnik nicht unnötig viele, die Chipfläche des integrierten Bausteins heraufsetzende Zähler oder sonstige Zeitglieder benutzen zu müssen, ist die Schaltung 700 vorgesehen, welche zur Ansteuerung der Zeitkonstanten-Baugruppen 701 dient. Die Schaltung 700 einschließlich einer Baugruppe 701 ist in Figur 7 mit den zugehörigen Impulsdiagrammen in den Figuren 7a bis f detailliert wiedergegeben.

Der Schaltungsteil 701 der Schaltung 700 in Figur 7 enthält zwei Flip-Flops 702 sowie 703, welche durch das Eingangssignal getaktet werden. Das Eingangssignal wird durch den in Figur 7 dargestellten Signalzug a als Beispiel dargestellt. Ein Multivibrator 704 erzeugt Impulse mit einer Wiederholrate von ca. 500 msec, wie es in dem Kurvenzug gemäß Figur 7f wiedergegeben ist. Die Ausgangssignale des Multivibrators werden mittels eines Inverters 705 invertiert und sowohl das ursprüngliche als auch das invertierte Signal mittels einer auf jeweils einer RC-Kombination gebildeten Differenziergliedern in Nadelimpulse umgewandelt, die jeweils zeitlich den ansteigenden (Kurvenzug Figur 7e) bzw. abfallenden (Kurvenzug Figur 7d) Flanken des Signals gemäß Figur 7f entsprechen. Die durch Differenzierung des nichtinvertierten Signals gewonnenen Impulse gemäß Signalverlauf e gelangen zu einem UND-Gatter 708, an dessen anderen Eingang der invertierende Ausgang Q des Flip-Flops 703 angeschlossen ist. Das Ausgangssignal des UND-Gatters 708 gelangt zum Reset-Eingang des Flip-Flops 702. Das differenzierte invertierte Signal d) dagegen zum Reset-Eingang des Flip-Flops 703. Durch die Ausgangssignale a des Flip-Flops 703 werden nur dann über das UND-Gatter 708 die Reset-Impulse für das FlipFlop 702 freigegeben, wenn für einen Zeitraum T/2 keine Eingangsimpulse innerhalb des Eingangssingals gemaß Figur 7a vorliegen. Es wird damit also stets eine Mindesthaltezeit gewährleistet, welche zwischen T/2 und T liegt. Hierdurch wird gewahrleistet, daß erst dann zurückgesetzt wird, wenn das Verhaltnis von Stör- zu Nutzsender mit Sicherheit einen geringeren Wert angenommen hat und folglich die Übertragungscharakteristik auf einen weniger selektiven Zustand geschaltet werden kann.

Beim dem in Figur 8 dargestellten detaillierten Schaltbild einiger in den Figuren 1 und 1 b wiedergegebenen Baugruppen handelt es sich um die Gleichrichterschaltung 27, den Integrator 27a, die Erkennungsschaltung für "schwaches Signal" 29, die Erkennungsschaltung für Nachbarkanalstörungen 30 und die Auswertungsschaltungen für Nachbarkanalstörungen NK₁ bis NK₃ 34 bis 36. Die Baugruppen sollen nachfolgend unter Kennzeichnung lediglich ihrer aktiven Bauelemente beschrieben werden, da die Anordnung der passiven Bauelemente sich aus der beschrieben Konfiguration und Funktion der einzelnen Stufen ergibt, wobei die einzelnen Stufen in ihrer Konfiguration und Funktion als bekannt zugrundegelegt werden.

Die erste Stufe mit einem Transistor 801 bildet eine übliche Verstärkerstufe. Der nachfolgende Transistor 802 bildet mit dem Kondensator 802a einen Hüllkurvengleichrichter, welchem ein Emitterfolger 803 nachgeschaltet ist, wobei die beiden Transistoren 802 und 803 komplementäre Typen bilden. Die nachfolgende Stufe 27a mit einem Operationsverstärker 804 stellt eine Integratorschaltung dar, welche am Ausgang die Regelspannung für die Regelstufe 1 abgibt.

Die nachfolgende Stufe 29 enthält einen Operationsverstärker 805 und dient als Komparator, wobei das Ausgangssignal des Operationsverstärkers 805 kennzeichnend für den Empfangszustand "schwaches Signal" ist. Dieses Signal wird abgegeben, wenn das Eingangssignal einen vorgegebenen Pegel, welcher am nichtinvertierenden Eingang des Operationsverstärkers 805 entsteht, unterschreitet. Als weitere wichtige Eigenschaft weist die Schaltung mit dem Operationsverstärker 805 eine Hysterese auf, welche für eine ausreichende Schaltsicherheit sorgt.

Die Schaltung 30 für die Nachbarkanalerkennung erhält ihr Ausgangssignal vom Ausgang der Stufe 27 (Transistor 803). Dieses Signal ist in Figur 8a wiedergegeben. Ein Eingangstransistor 806 enthält einen zugeordneten Hochpaß. In den darauffolgenden aus Transistoren 807, 808 sowie einem Operationsverstärker 809 bestehenden Stufen erfolgt eine Signalverstärkung um 40 dB. Dem Ausgang des Operationsverstärkers ist ein weiterer Transistor 810 mit einem Kondensator C 810a als Hüllkurvendemodulator nachgeschaltet, auf den ein Emitterfolger 811 folgt, dem ein Tiefpaß 811a - bestehend aus einer RC-Kombination - vorangeschaltet ist. An den Emitter des Transistors 811 sind die Eingänge der Stufen 34 bis 36 angeschlossen, welche Komparatorschaltungen bilden und Operationsverstärker 812 bis 814 enthalten. Den nichtinvertierenden Eingängen dieser Operationsverstärker 812 bis 814 werden unterschiedliche Gleichspannungspegel zugeführt, welche die Bezugsgröße für die Diskrimination der Nachbarkanalstörungen in den Stufen 34 bis 35 bilden.

An den Ausgängen der Operationsverstärker 812 bis 814 werden die für Nachbarkanalstörungen kennzeichnenden Signale NK₁ bis NK₃ abgegriffen. Jeder Hysteresestufe 34 bis 36 zugeordnet ist jeweils ein - über Inverter 815 bis 817 angesteuerter - Transistor 818 bis 820, der die betreffende Schwellspannung durch Abschalten eines Parallelwiderstandes dann reduzuiert, wenn das zugeordnete logisch weiterverarbeitete Nachbarkanalstörungssignal NK₁', NK₂' bzw. NK₃' erscheint. Auf diese Weise werden unkontrollierte Signalübergänge vermieden. Die Inverter sorgen jeweils dafür, daß der zugeordnete Schalttransistor gesperrt wird, also kein den Transistor durchschaltendes Eingangssignal an der Basis ansteht, wenn der betreffende Nachbarkanalstörungszustand durch das entsprechende Ausgangssignal des zugeordneten Operationsverstärkers 812 bis 814 ausgegeben wird. Die Hystereseschaltung berücksichtigt die anhand der Figuren 6 und 7 beschriebenen Zeitsteuerung, so daß das zeitlich bewertete mit einem ""' versehene, zur Weiterverarbeitung bestimmte Signal als Bezugssignal für die Hystereseschaltung verwendet wird.

Bei der dargestellten NK-Erkennungsschaltung erfolgt also nach Hochpaßfilterung, Verstärkung, Hüllkurvenbildung, Tiefpaßglättung des gleichgerichteten ZF-Signals eine Pegelerkennung.

Für die nachfolgende Nachbarkanalerkennung wird die Interferenz erkannt, die sich zwischen Nutz- und Nachbarkanal bildet. Ein nachfolgender Hochpaß ist für die zwischen Nutz- und Nachbarkanal auftretende Interferenz ausgelegt' die im ZF-Signal als Amplitudenmodulation erkennbar sind, wie es in Figur 8b dargestellt ist.

Das Interferenzsignal im Bereich von Frequenzen ab etwa 60 kHz wird herausgefiltert, wobei andere als Amplitudenmodulation auf der ZF befindliche Signale eliminiert werden und das Interferenzsignal als Kennzeichen der Nachbarkanalstörung zurückbleibt (Figur 8c). Das Filter weist eine untere Grenzfrequenz von etwa 40 kHz auf und ist als zweipoliger Hochpaß ausgebildet. Die anschließende Verstärkung erfolgt über einen normalen Transistor dem der Operationsverstärker nachgeschaltet ist.

Die durch die beschriebenen Hystereseschaltungen bewirkte Umschaltung des Eingangspegels für die durch die Operationsverstärker gebildeten Erkennungsschaltungen sorgt auch dafür, daß die durch die Änderung der Bandbreite bei der Signalverarbeitung bewirkten Pegeländerungen nicht ein sofortiges Zurückschalten nach der Veränderung der Signalverarbeitung im System auf die erkannte Signalbedingung hin erzeugen.

Sobald die Verarbeitung schmalbandiger wird, gehen gleichzeitig beide Informationen über die Interferenz zurück, so daß die betreffende Nachbarkanalerkennungsschaltung nicht mehr ansprechen würde. Ohne Kompensationsmaßnahmen wäre eine unerwünschte Schwingung des Ausgangssignals der Erkennungsstufe die Folge. Die beschriebene Hystereseschaltung wirkt jedoch diesem unerwünschten Zustand entgegen, in dem nach Erkennung der jeweiligen Signalbedingung die Vergleichsspannung abgesenkt wird, so daß auch die nach Verringerung der Filterbandbreite verbleibende Hüllkurvenamplitude noch die Ansprechspannung überschreitet.

In Figur 9 ist die Schaltung für die Erkennung der Nachbarkanalübernahme dargestellt.

Diese Schaltung wertet ein bei kurzzeitiger Übernahme des Signals des Nachbarkanalsenders entstehendes starkes "Plop"-Geräusch aus. Das Eingangssignal gemäß Figur 9a zeigt den Sprung, wie er aus der tiefpaßgefilterten NF am Ausgangs des Reglers 27 zur Verfügung steht. Ein aus einem Längswiderstand 901 und einem darauffolgenden nach Masse geschalteten Kondensator 902 gebildete RC-Kombination wirkt als Tiefpaß, so daß am Punkt b das in Figur 9b dargestellte geglättete Signal ansteht. Dieses Signal wird einem ein als Emitterfolger geschalteten Transistor 903 zugeführt, der als Impedanzwandler für einen nachfolgenden Operationsverstärker 904 dient. Dieser vergleicht das anstehende Signal mit einem über einen Spannungsteiler an seinem nicht-invertierenden Eingang erzeugten Bezugspegel von ca. 2 Volt mit einer gegen Schaltsicherheit dienenden Hysterese. Das Überschreiten dieses Bezugspegels ruft am Ausgang des Operationsverstärkers 904 einen Spannungsimpuls hervor, welcher als Erkennungssignal für die erfolgte Nachbarkanalübernahme der Weiterverarbeitung - wie beschrieben - zugeführt wird.

Bei der in Figur 10 dargestellten Schaltung gelangt das Eingangssignal zunächst zu einem Bandpaß 101. Diese Schaltung erkennt Reflexionen anhand von ZF-Einschnürungen in einem Bereich des Signalgemisches, welches geringfügig oberhalb von 38 kHz liegt. Diese Abstimmung weist den überraschenden Vorteil auf, daß in diesem Signal bereits durch Reflexionen hervorgerufene Verzerrungen erkannt werden, wenn das 19 kHz Hilfsträgersignal noch ungestört erscheint. Durch die Erkennung von Störungen im genannten Bereich lassen sich solche Störungen detektieren, die das Stereosignal beeinträchtigen, obwohl der Hilfsträger noch keinerlei nachteilige Beeinflussung erkennen läßt. Bei einer vereinfachten Ausführung kann auch gegebenenfalls auf die Frequenzfilterung verzichtet werden.

Eine nachfolgende Transistorstufe 102 bildet einen Impedanzwandler. In der dann folgenden Transistorstufe 103 erfolgt eine Verstärkung um ca. 15 db. Der anschließende einem Emitterfolger 104 nachgeschaltete Operationsverstärker 105 wirkt als Schwellendiskriminator, wobei der nichtinvertierende Eingang an einen durch einen Spannungsteiler gebildeten Bezugspegel von ca. 3,5 bis 4,4 Volt angeschlossen ist. Durch die ausgewerteten Spannungsüberhöhungen am Schwingkreis 101 erfolgt die Rückschaltung des Stereodecoders auf Mono- Betrieb (Signal d1).

Vor der Operationsverstärkerschaltung 105 wird ein Signal a abgezweigt, welches ein alnaloges Steuersignal für die Mute-Schaltung (entsprechend der in Figur 1 gestrichelt angedeuteten Variante) bildet. Bei größerer Tiefe der von den vorangehenden Stufen ausgewerteten Einschnürungen, wie sie Rauschstörungen entsprechen, wird über die Schaltung 25 in Figur 1 b, eine Verringerung des NF-Pegels eingeleitet. (Die Zurückschaltung auf Mono bei Reflexionen beruht hingegen auf Einschnürungen des ZF-Signals bei hohen Signalpegeln (Signalkennzeichnung "Schwaches Signal" nicht vorhanden - Figur 2).

Mittels einer weiteren einen zweiten Schwellendiskriminator bildenden Operationsverstärkerschaltung 106, die bei einem etwa um den Faktor 1:2,5 niedriger gelegenen Pegel anspricht, wird ein digitales Signal (Ausgang d2) erzeugt, das zur Antennenumschaltung bei Antennendiversity zur Verfügung steht. Wenn also die auf ein "Aufrauschen" des ZF-Signals hindeutenden Einschnürungen bei niedrigem Signalpegeln einen vorgegebenen Wert unterschreiten, ist die Empfamgsqualität soweit abgesunken, daß durch Auswertung der digitalen Schaltflanke am Ausgang des Operationsverstäkers 106 ein Antennenschaltimpuls ausgelöst wird, um mit einer anderen Antenne möglicherweise günstigere Empfangsbedingungen anzutreffen.

In Figur 11 ist die Erkennungsschaltung 33 für die Feldstärke zur Steuerung der Mutingschaltung 25 wiedergegeben.

Wie eingangs erwähnt, wird die ZF von 700 kHz auf einen festen Spannungswert geregelt. Der Regeleinsatz beginnt bei relativ kleinen Eingangsfeldstärken, etwa an der Grenze der Empfangswürdigkeit eines Senders. Unterhalb dieses Pegels, also unterhalb des Regeleinsatzpunktes, ändert sich die ZF bis zum Leerlaufrauschen proportional zur Eingangsfeldstärke. Sie eignet sich daher ideal als Muting-Kriterium. Durch Hüllkurvendemodulation der ZF und anschließende Glättung durch einen Tiefpass wird eine Gleichspannung gewonnen, die dem Muting-Abschwächer als Steuersignal zugeführt wird.

Die Schaltung spricht an unterhalb des Einsatzpunktes der Regelung. Die Regelung setzt bereits bei ungefähr 1 uV Antenneneingangsspannung ein. Das über Diode 111 geleitete Eingangssignal gelangt zu einem nachgeschalteten Tiefpaß 112 mit einer Grenzfrequenz von ca. 20 Hz.

Das NF-Signal wird jedoch nicht nur bei geringen Feldstärken abgesenkt, sondern auch bei Reflexionsstörungen. Vor dem Tiefpaß zur Glättung der ZF-Hüllkurve ist hierzu die Diode mit anschließendem RC-Filter angeordnet, durch welche bei Reflexionseinschnürungen unterschiedliche Zeitkonstanten für die an- und abfallenden Flanken wirksam sind, in der Weise, daß der Mittelwert, welcher durch den obengenannten Tiefpaß gebildet wird, mit zunehmender Einschnürtiefe sich in gleicher Weise ändert, wie der Mittelwert bei schwächer werdendem Signal.

Die weitere Signalverarbeitung erfolgt durch Impedanzwandlung mit einem nachgeschalteten Emitterfolger 113 und nachfolgender Pegelheraufsetzung mit einem Operationsverstärker 114.

Ein weiteres an den Ausgang des Operationsverstärkers 114 angeschlossenes Tiefpaß-T-Filter 115 mit einer Grenzfrequenz von ca. 4 Hz stellt sicher, daß normale längerfristige Fading-Einbrüche in Form von relativ langsamen Signalschwankungen erst mit einer gewissen "Verzögerungszeit" wirksam werden, um zu häufige und störende Schaltvorgange zu vermeiden.

Da die Steuerspannung für den Muting-Abschwächer ausreichend geglättet sein muß, ist eine gewisse Mindestzeitkonstante für den Tiefpaß erforderlich. Hierdurch erhält die Muting Spannung eine gewisse Trägheit; sie kann wohl Feldstärkeschwankungen bis etwa 4 Hz folgen, ist jedoch für schnelle Fading-Einbrücke zu langsam.

Ein weiterer dem Ausgang des Operationsverstärkers 114 unmittelbar nachgeschalteter als Schwellendiskriminator wirksamer Operationsverstärker 116 erkennt sehr schnelle und in dieser Form besonders störende Fadingeinbrüche, bei denen die gleichgerichtete ZF kurzfristig eine Schwelle unterschreitet. Das Ausgangssignal des Operationsverstärkers 116 gelangt an einen Schalttransistor 117, der nach Art einer "ODER-Verknüpfung" das Ausgangssignal der in Figur 11 dargestellten Schaltung kurzschließt und damit einen Signalzustand erzielt, der von der nachfolgenden Schaltstufe ebenfalls als "Muting"-Befehl ausgewertet wird.

Über den zweiten Tiefpaß mit geringerer Zeitkonstante, wird ein weiteres, schnell folgendes, jedoch mit starkem Rippel behaftetes Signal erzeugt. Dieses Signal wird einem Komparator zugeführt, der dann ein sauberes Schaltsignal abgibt, wenn ein tiefes Feldstärkeniveau, kurz oberhalb des Leerlaufrauschens, erreicht wird. Mit diesem Signal wird der Muting-Abschwächer schlagartig auf seine höchste Absenkung, d.h. auf die Restlautstärke geschaltet.

Es sei nicht verkannt, daß hinsichtlich des Muting-Verhaltens von Geräten, die unterschiedlichsten Ansichten bestehen: Von sehr früh einsetzendem, auf sehr tiefes Niveau reichendes, bis zu gar keinem Muting, also konstanter Lautstärke über den gesamten Lautstärkebereich.

Die hier angebotene Kombination eines geringfügig trägen, den Gaußschen Feldstärkeschwankungen folgenden weichen Mutings, die auch Erkennung von Reflexionsstörungen einschließt, mit dem schnell einsetzenden Fading-Muting, ist in ihrer Dosierung durch externe Bauelemente frei dosierbar. Selbstverständlich muß diese Schaltung nicht eingesetzt werden, sie steht jedenfalls als Muting Instrumentarium zur Verfügung.

Bei dem in Figur 12 dargestellten Ausführungsbeispiel des erfindungsgemäßen Empfangsteils hat der die zuvor dargestellten Schaltungen enthaltende FM-Empfangsteil die Konfiguration eines UKW-FM-Autoradios 120 mit zwei angeschlossenen Lautsprechern 121 und 122.

Zum Zusammenwirken der verschiedenen Schaltungen zur Änderung des Verarbeitungskanals in dem beschriebenen Empfängersystem gelten die folgenden Überlegungen:
Die Nachbarkanalerkennung wertet die Interferenz aus, die zwischen Nutz- und Nachbarsender entsteht. Diese Reflexion hat auf die Filterzustände keinen Einfluß. Wenn Reflexionen erkannt werden, wird zunächst einmal von Stereo auf Mono umgeschaltet, wodurch viele Reflexionsstörungen bereits in ihrer Auswirkung beseitigt sind. Bei stärkeren Reflexionsstörungen reicht eine derartige Beseitigung aber noch nicht aus. Günstig ist deshalb eine zusätzliche Muting-Schaltung. Sie beseitigt auch einen Teil solcher Reflexionsstörungen, die bei Umschaltung auf Mono-Betrieb im NF-Signal als störend verbleiben.

Es wirken also bei dem erfindungsgemäßen System im wesentlichen zwei Gruppen von Steuergrößen: die erste verschiebt diese ganze Anordnung in ihrer Resonanzlage. Steilflankige Filter werden mit einer Hochpaß-Charakteristik gesteuert, breitbandigere Filter dagegen mit einer gewissen Tiefpaß-Charakteristik.

Im folgenden sei für die Leistungsfähigkeit des beschriebenen Empfangssystems noch anhand einiger Empfangssituationen verdeutlicht:
Im 100 kHz Abstand kann ein Stereo-Nachbarsender etwa die 10-fache Feldstärke des Nutzsenders aufweisen, bevor Störungen auftreten (ohne die erfindungsgemäße Schaltung treten Störungen etwa bei gleichem Verhältnis von Nutz- zu NK-Sender auf).

Im 200 kHz Abstand kann die Feldstärke eines Stereo-NK-Senders etwa 30 dB höher liegen, als diejenige, bei welcher mit einem normalen Empfänger Störungen auftreten.

Liegt ein NK-Sender im 200 kHz Abstand, so bedeutet der Selektionsgewinn, daß, sofern Stereoempfang vorliegt, dieser nahezu unabhängig von der Höhe des NK-Senders erhalten bleibt. NK-Sender im 200 kHz Abstand reichen, auch wenn sie stark sind, mit ihrem Spektrum nicht derart tief in den Empfangskanal, daß dabei die höchste Selektionsstufe NK₃, bei welcher Monoempfang vorliegt, anspricht.

Ein Selektionsgewinn von 30 dB bedeutet weiter, daß auch bei geringen Nutzfeldstärken weit unterhalb der Stereoschwelle der Übernahmebereich durch einen NK-Sender im 200 kHz Abstand fast nie erreicht wird. Der NK-Sender müßte etwa um den Faktor 30 in der Feldstärke höher liegen, was einer 900-fach höheren Sendeleistung entspricht, als bei konventionellen Empfängern.

Besonders krass wird die Verbesserung der Empfangsleistung, wenn Empfindlichkeit und Selektion im gleichen Maße gefordert sind, etwa bei einem ohnehin stark verrauschten Nutzsender bei gleichzeitigen starken Nachbarkanal-Sendern. Einem Gemisch von Rauschen und verzerrten Übersprechmodulationen als Empfangsprodukt eines konventionellen Empfängers steht ein klarer Empfang des Nutzsenders bei der erfindungsgemäßen Lösung gegenüber.

Die Verbesserungen erfolgen ohne Beeinflussung des Klirrfaktors oder Stereo-Übersprechdämpfung. Bei den beiden Vollstereo-Zuständen NKo und NK₁ liegt der Klirrfaktor bei 75 kHz Hub und 1 kHz NF unter 1%. Die Stereo-Übersprechdämpfung liegt bei 1 kHz bei 30 dB, bei 5 kHz bei 22 dB.

Die Erfindung beschränkt sich in ihrer Ausführung nicht auf das vorstehend angegebene bevorzugte Ausführungsbeispiel. Vielmehr ist eine Anzahl von Varianten denkbar, welche von der dargestellten Lösung auch bei grundsätzlich anders gearteten Ausführungen Gebrauch machen. Insbesondere beschränkt sich die Ausführung nicht auf die Realisierung mit diskreten logischen Baugruppen, sondern läßt sich vorteilhaft auch mit programmierter Logik - vorzugsweise unter Verwendung eines Mikroprozessors - realisieren.

## Patentansprüche

1. FM-Rundfunkempfangsteil mit Mitteln zur Nachsteuerung der Mittenfrequenz eines bezüglich der Kanalbandbreite relativ schmalbandigen ZF-Filters in Abhängigkeit von der Nutzmodulation, mit einem einen ZF- und einen NF-Teil enthaltenden Signalverarbeitungsteil zur Verstärkung, Frequenzumsetzung und Demodulation des empfangenen FM-Signals,
gekennzeichnet durch
eine Schaltung zur Veränderung der Signal- übertragungscharakteristik des ZF- und/oder NF-Teils, enthaltend
einen Signalerkennungsteil (28), mit Schaltungen (29 bis 33) zur Erfassung von für Empfangs- oder Störungszustände kennzeichnenden Größen, deren Eingänge jeweils mit einem das zu verarbeitende Signal führenden Schaltungspunkt des ZF- oder NF-Teils verbunden sind, und Ausgängen für Empfangs- bzw. Störungszustände kennzeichnende Signale,
einen Signalaufbereitungsteil (600) für Empfangs- bzw. Störungszustände kennzeichnende Signale mit mindestens einer Amplituden- und/oder Zeitschwellenschaltung, dessen Eingänge mit den Ausgängen des Signalerkennungsteils verbunden sind, sowie
einem Signalverknüpfungsteil zur Erzeugung von Ausgangssignalen unter logischer und/oder zeitabhängiger Verknüpfung der vor Signalaufbereitungsteil abgegebenen Signale als Teil
eines Signalausgabeteils (200, 400) zur Abgabe der aufbereiteten für Empfangs- bzw. Störungszustände kennzeichnenden Signale als Steuersignale zur Beeinflussung der Verarbeitungscharakteristik des Signalverarbeitungsteils an einzelne Stufen des ZF-bzw. NF-Teils, wobei Eingänge des Signalausgabeteils mit Ausgängen des Signalaufbereitungsteils und die Ausgänge des Signalausgabeteils mit Steuereingängen von Stufen des ZF-bzw. NF-Teils verbunden sind.

2. FM-Empfangsteil nach Anspruch 1, dadurch gekennzeichnet, daß der Signalverknüpfungsteil ein- oder mehrstufig logische Baugruppen aufweist, welche Ausgangssignale auf Eingangssignale entsprechend der Zuordnung einer Wahrheitstabelle abgeben.

3. FM-Empfangsteil nach Anspruch 1, dadurch gekennzeichnet, daß die Steuersignale zur Beeinflussung der Signalverarbeitungscharakteristik des Signalverarbeitungsteils bestehen in
mindestens einem Schaltsignal als Eingangssignal für den Steuereingang einer Schaltstufe (9, 12) zur zusätzlichen Ein- oder Ausschaltung eines parallelen Frequenzfilter-oder linearen Signalverarbeitungswegs im ZF-und/oder NF-Teil und/oder
mindestens einem Schaltsignal als Eingangssignal für den Steuereingang einer Schaltstufe (6, 7, 10, 11) zur Veränderung der Symmetrie mindestens einer Filterdurchlaßkurve, insbesondere zur Linarisierung des resultierenden NF-Signals, und/oder
mindestens einem Schaltsignal als Eingangssignal für den Steuereingang einer Schaltstufe (26) zum Einschalten von Monobetrieb und/oder
mindestens einem Schaltsignal als Eingangssignal für den Steuereingang einer Schaltstufe zur mindestens mittelbaren Änderung der Nachführcharakteristik (17 bis 22) der Frequenznachführung der ZF-Filter und/oder
mindestens einem Schaltsignal als Eingangssignal für den Steuereingang einer schaltstufe (4) Signal zur Veränderung, insbesondere Zu- und Abschaltung, der Steuerspannung des Phasenmodulators der Oszillatorspannung.

4. FM-Empfangsteil nach Anspruch 3, dadurch gekennzeichnet, daß das mindestens eine Schaltsignal zur zusätzlichen Ein- oder Ausschaltung eines parallelen Frequenzfilter- oder linearen Signalverarbeitungswegs im ZF-und/oder NF-Teil bzw. ein Eingangssignal für den Steuereingang einer Schaltstufe (9 bis 12) bildet, die
bei Nachbarkanalstörungen der ZF-Teil in Abhängigkeit von dem durch das aufbereitete Interferenzsignal jeweils überschrittenen Schwellwert in einer oder mehreren Stufen schmalbandiger schaltbar und der höherfrequente Anteil des NF-Signals angehoben wird und/oder
bei geringem Eingangssignalpegel die ZF- Übertragungscharakteristik beidseitig einem von der Bandmitte her symmetrisch steilen Frequenzabfall sich schulterförmig anschließende Bereiche aufweist, die zu den Kanalgrenzen hin weniger stark abfallen und/oder
unterhalb eines sehr geringen Eingangssignalpegels, insbesondere bei Unterschreitung eines Schwellwertes, der dem Einsatzpunkt der Regelung entspricht, das NF-Signal im Pegel abgesenkt wird, wobei insbesondere kurzzeitige Signaleinbrüche ein unverzögertes Absenken des NF-Signalpegels bewirken.

5. FM-Empfangsteil nach Anspruch 3, dadurch gekennzeichnet, daß das mindestens eine Schaltsignal, welches eine Schaltung zur Änderung der Nachführcharakteristik der Frequenznachführung der ZF-Filter und/oder der Phasensteuerung aktiviert, weiterhin das Eingangssignal für den Steuereingang einer Schaltstufe (17 bis 20) bildet,
zur Absenkung des Frequenzgangs der Filternachführung und/oder Phasensteuerspannung in Abhängigkeit vom Verhältnis von Nachbarkanalpegel zu Nutzsignalpegel geändert wird und insbesondere bei schmalbandigerer ZF-Verarbeitung zu hohen Frequenzen hin,
zur Ausschaltung des Steuersignal für die Phasenmodulation bei der Filternachführung bei insbesondere breitbandiger ZF-Verarbeitung und/oder
zur Abschaltung der Filternachführung insgesamt bei Detektion eines vorgebenen Spannungssprungs im ZF-und/oder unteren NF-Signal, hervorgerufen durch eine kurzzeitige Nachbarkanalübernahme.

6. FM-Empfangsteil nach einem der vorangehenden Ansprüche, dadurch gekennzeichnet, daß mindestens ein Eingangssignal für den Signalerkennungsteil (28) bildet:
das Ausgangssignal eines ZF-Bandfilters (6), das nicht von Umschaltungen oder Zu- und Abschaltungen von Signalwegen betroffen ist, welches die auf einen festen Mittelwert geregelte ZF abgibt und/oder
das Ausgangssignal einer Integratorschaltung (17a) als Eingangssignal für die Regelstufe zur Amplitudenregelung des ZF-Signals zugeführt wird, und/oder
das demodulierte ZF-Signal.

7. FM-Empfangsteil nach Anspruch 1, dadurch gekennzeichnet, daß Kompensationsmittel (8a) für die Amplitude des ZF-Signals vorgesehen sind, welche bei Einschaltung einer Bedämpfung des ZF-Signals innerhalb des Regelkreises infolge eines entsprechenden Steuersignals die daraus resultierende Pegelabsenkung gleichzeitig so kompensieren, daß die Regelspannung für die Amplitude des ZF-Signals dabei im wesentlichen seinen Pegel beibehält.

8. FM-Empfangsteil nach Anspruch 1, dadurch gekennzeichnet, daß eine Schaltstufe (114, 116) mit einer Hysterese bei Änderung des Übertragungsfrequenzgangs oder der Verstärkung in einem Signalübertragungsweg vorgesehen ist, welche die Rückschaltschwelle um einen solchen Wert gegenüber der Ansprechschwelle verändert, daß damit die durch die Umschaltung in Bezug auf das mit der Signalschwelle zu vergleichende Signal bewirkte Änderung mindestens ausgeglichen ist, insbesondere, daß die Reduktion des Nachbarkanalerkennungssignals infolge der schmalbandigeren ZF-Verarbeitung nach Ansprechen der Erkennungsstufe für Nachbarkanalstörungen mindestens ausgeglichen ist.

9. FM-Empfangsteil nach Anspruch 1, dadurch gekennzeichnet, daß logische Schaltmittel (601 bis 606) vorgesehen sind, welche bei Änderung des Übertragungsfrequenzgangs oder der Verstärkung in einem Signalübertragungsweg bei mehreren vorgesehenen Ansprechschwellen, wobei die mit den Ansprechschwellen zu vergleichenden Signale durch ein mit dem Unterschreiten ausgelöstes Signal hin heraufgesetzt werden, das Ansprechen der der nächstniedrigeren Schaltschwelle zugeordneten Schwellwertstufe verhindern, bis die nächsthöhere Schaltschwelle angesprochen hat.

10. FM-Empfangsteil nach Anspruch 1, dadurch gekennzeichnet, daß logische Schaltmittel (200) vorgesehen sind, welche bei Ausgangssignalen der Signalaufbereitungsschaltung, die zu Steuersignalen führen, welche neben einer Verringerung der ZF-Durchlaßbandbreite noch weitere Umschaltungen auslösen, nur solche Ausgangssignale der Signalaufbereitungsschaltung zulassen, welche jeweils die schmalste ZF-Durchlaßkurve zur Folge haben.

## Claims

1. An FM radio receiver unit with means for tracking the mid frequency of an IF filter which is narrow band relative to the channel band width, dependent on the effective modulation, comprising a signal processing unit containing an IF and an LF unit for amplification, frequency conversion and demodulation of the FM signal received, characterised by a circuit for changing the signal transmission characteristic of the IF and/or LF unit, containing
a signal recognition unit (28), with circuits (29 to 33) for registering magnitudes indicating reception or interference states, their inputs each being connected to a switching point of the IF or LF unit carrying the signal to be processed, and with outputs for signals indicating reception or interference states,
a signal conditioning section (600) for signals characterising reception or interference states, with at least one amplitude and/or time threshold circuit, the inputs of which are connected to the outputs of the signal recognition section, and
a signal processing section for generating output signals with logical and/or time-dependent treatment of the signals emitted by the signal conditioning section, as part
of a signal output unit (200, 400) for emitting the conditioned signals indicating reception or interference states as control signals for influencing the processing characteristic of the signal processing unit to individual stages of the IF or LF unit, inputs of the signal output unit being connected to outputs of the signal conditioning unit, and the outputs of the signal output unit being connected to control inputs of stages of the IF or LF unit.

2. An FM receiver unit according to claim 1, characterised in that the signal processing section has logic assemblies in one or more stages, which emit output signals in response to input signals according to allocation in a truth table.

3. An FM receiver unit according to claim 1, characterised in that the control signals for influencing the signal processing characteristic of the signal processing section comprise
at least one switching signal as an input signal for the control input of a switching stage (9, 12) for additionally switching on or off a parallel frequency filtering path or linear signal processing path in the IF and/or LF section and/or
at least one switching signal as an input signal for the control input of a switching stage (6, 7, 10, 11) for changing the symmetry of at least one filter pass-band curve, particularly for linearising the resultant LF signal, and/or
at least one switching signal as an input signal for the control input of a switching stage (26) for switching on mono operation and/or
at least one switching signal as an input signal for the control input of a switching stage for at least indirectly changing the tracking characteristic (17 to 22) of the frequency tracking of the IF filters and/or
at least one switching signal as an input signal for the control input of a switching stage (4), a signal for changing the control voltage of the phase modulator of the oscillator voltage, particularly switching it in and off.

4. An FM receiver unit according to claim 3, characterised in that the switching signal, of which there is at least one, serves additionally to switch on or off a parallel frequency filtering path or linear signal processing path in the IF and/or LF section, or forms an input signal for the control input of a switching stage (9 to 12) which
in the event of adjacent channel interference to the IF section, dependent on the threshold value which is exceeded in any particular case by the conditioned interference signal, can be made more narrow-band in one or more stages, and the higher-frequency component of the LF signal is raised and/or
in the event of a low input signal level, the IF transmission characteristic has portions which adjoin a frequency drop in a shoulder shape at both sides, the drop being symmetrically steep from the centre of the band, and said portions drop less sharply towards the channel limits and/or
below a very low input signal level and particularly below a threshold value corresponding to the point where control is initiated, the level of the LF signal is lowered and short-time dips in signal level in particular cause non-delayed lowering of the LF signal level.

5. An FM receiver unit according to claim 3, characterised in that the switching signal, of which there is at least one and which activates a circuit for changing the tracking characteristic of frequency tracking of the IF filters and/or of the phase control, further forms the input signal for the control input of a switching stage (17 to 20)
for lowering the frequency response of the filter tracking and/or phase control voltage, is changed dependent on the relationship between the adjacent channel level and the wanted signal level, the change being to high frequencies particularly during more narrow-band IF processing,
for switching off the control signal for the phase modulation during filter tracking, particularly during broad-band IF processing and/or
for switching off filter tracking altogether on detection of a predetermined voltage jump in the IF and/or lower LF signal, caused by a short-time take-over of an adjacent channel.

6. An FM receiver unit according to any of the preceding claims, characterised in that at least one input signal for the signal recognition section (28) forms:
the output signal of an IF band filter (6) which is not affected by switching over or connecting or disconnecting signal paths and which emits the IF adjusted to a fixed mean value and/or
the output signal of an integrator circuit (17a) is supplied as an input signal for the control stage for amplitude control of the IF signal and/or
the demodulated IF signal.

7. An FM receiver unit according to claim 1, characterised in that means (8a) for compensating for the amplitude of the IF signal are provided, and that when attenuation of the IF signal is activated within the control circuit owing to a corresponding control signal the resultant drop in level is simultaneously compensated, in such a way that the voltage for controlling the amplitude of the IF signal substantially maintains its level.

8. An FM receiver unit according to claim 1, characterised in that a switching stage (114, 116) is provided with a hysteresis on a change of transmission frequency response or amplification in a signal transmission path, which changes the switch-back threshold relative to the response threshold by a value such that the change produced by the switch-over in respect of the signal to be compared to the signal threshold is at least compensated for, and particularly that the reduction in the adjacent channel recognition signal, resulting from narrower-band IF processing when the recognition stage for adjacent channel interference has responded, is at least compensated for.

9. An FM receiver unit according to claim 1, characterised in that logical switching means (601 to 606) are provided, and that on a change of transmission frequency response or of amplification in a signal transmission path when a plurality of response thresholds are provided, with the signals which have to be compared to the response thresholds being raised by a signal triggered by the drop below the thresholds, the logical switching means prevent the threshold value stage associated with the next switching threshold down from responding until the next switching threshold up has responded.

10. An FM receiver unit according to claim 1, characterised in that logical switching means (200) are provided, and that in the event of output signals of the signal conditioning circuit leading to control signals which trigger still further switching over processes as well as reducing the IF pass-band band width, the means (200) only allow output signals of the signal conditioning circuit which give the narrowest IF pass-band curve in each case.

## Revendications

1. Partie d'un récepteur à modulation de fréquence comportant des moyens pour effectuer une poursuite en fréquence sur la fréquence centrale d'un filtre à fréquence intermédiaire, de bande relativement étroite par rapport à la largeur de bande du canal, en fonction de la modulation utile, comportant aussi une partie de traitement du signal, contenant une partie à fréquence intermédiaire et une partie à basse fréquence, pour amplifier, convertir en fréquence et démoduler le signal à modulation de fréquence reçu,
partie caractérisée par
un circuit pour modifier la caractéristique de transmission du signal de la partie à fréquence intermédiaire et/ou de la partie à basse fréquence, circuit contenant
une partie (28) de reconnaissance du signal, comportant des circuits (29 à 33) qui sont prévus pour saisir des grandeurs caractéristiques des états de réception ou de perturbation, dont les entrées sont chacune reliées avec un point de commutation, où passe le signal à traiter, de la partie à fréquence intermédiaire ou de la partie à basse fréquence, et dont les sorties donnent des signaux caractérisant les états de réception ou de perturbation,
une partie (600) de traitement du signal pour les signaux caractérisant les états de réception ou de perturbation, comportant au moins un circuit à seuil d'amplitude et/ou de durée dont les entrées sont reliées aux sorties de la partie de reconnaissance du signal, ainsi que
une partie de liaison logique des signaux pour produire des signaux de sortie à l'aide d'une liaison logique et/ou fonction du temps des signaux émis par la partie de préparation du signal, en tant que partie
d'une partie d'émission du signal (200, 400) pour émettre les signaux préparés, caractérisant les états de réception ou de perturbation, en tant que signaux de commande pour influencer la caractéristique de traitement de la partie de traitement du signal aux différents étages de la partie à fréquence intermédiaire ou de la partie à basse fréquence, étant précisé que les entrées de la partie d'émission du signal sont reliées avec les sorties de la partie de préparation du signal et que les sorties de la partie d'émission du signal sont reliées avec les entrées de commande des étages de la partie à fréquence intermédiaire ou de la partie à basse fréquence.

2. Partie d'un récepteur à modulation de fréquence selon la revendication 1, caractérisée par le fait que la partie de liaison logique des signaux présente un ou plusieurs groupes logiques à plusieurs étages qui émettent des signaux de sortie en réponse à des signaux d'entrée en Fonction de la correspondance d'une table de vérité.

3. Partie d'un récepteur à modulation de fréquence selon la revendication 1, caractérisée par le fait que les signaux de commande prévus pour influencer la caractéristique de traitement du signal de la partie du traitement du signal sont constitués de
au moins un signal de commutation comme signal d'entrée pour l'entrée de commande d'un étage de commutation (9, 12) pour commander la mise en circuit ou hors circuit supplémentaire d'un chemin parallèle à filtre de fréquence ou d'un chemin linéaire de traitement du signal dans la partie à fréquence intermédiaire et/ou dans la partie à basse fréquence et/ou
au moins un signal de commutation comme signal d'entrée pour l'entrée de commande d'un étage de commutation (6, 7, 10, 11) pour modifier la symétrie d'au moins une courbe de réponse en bande passante d'un filtre, en particulier pour linéariser le signal basse fréquence résultant, et/ou
au moins un signal de commutation comme signal d'entrée pour l'entrée de commande d'un étage à commutation (26) pour passer en exploitation en monophonie et/ou
au moins un signal de commutation comme signal d'entrée pour l'entrée de commande d'un étage de commutation pour modifier, au moins en moyenne, la caractéristique (17 à 22) de reprise de réglage de la fréquence centrale du filtre à fréquence intermédiaire et/ou
au moins un signal de commutation comme signal d'entrée pour l'entrée de commande d'un étage de commutation (4) pour modifier, en particulier pour mettre en circuit et hors circuit, la tension de commande du modulateur de phase de la tension de l'oscillateur.

4. Partie d'un récepteur à modulation de fréquence selon la revendication 3, caractérisée par le fait que le signal de commutation, dont il y a au moins un, prévu pour la mise en circuit ou hors circuit supplémentaire d'un chemin parallèle à filtre de fréquence ou d'un chemin linéaire de traitement (du signal dans la partie à fréquence intermédiaire et/ou dans la partie basse fréquence, forme un signal d'entrée pour l'entrée de commande d'un étage de commutation (9 à 12),
par le fait que
dans le cas de perturbations provoquées par le canal voisin, la partie à fréquence intermédiaire, en fonction de la valeur de seuil respectivement dépassée par le signal d'interférence préparé, peut commuter, en bande étroite, en un ou plusieurs étages et par le fait que la composante de la fréquence la plus élevée du signal basse fréquence est renforcée et/ou
que dans le cas d'un faible niveau du signal d'entrée, la caractéristique de transmission à fréquence intermédiaire présente des zones qui se raccordent, des deux côtés, en forme d'épaule, à une rapide chute de fréquence, symétrique par rapport au milieu de la bande, et qui tombent moins brusquement en allant vers les limites du canal et/ou
que dans le cas d'un très faible niveau du signal d'entrée, en particulier en cas de (dépassement, par valeur inférieure, d'une valeur de seuil qui correspond au point de mise en oeuvre de la régulation, le niveau du signal basse fréquence est abaissé, étant précisé qu'en particulier de brèves disparitions du signal opèrent sans retard un abaissement du niveau du signal basse fréquence.

5. Partie d'un récepteur à modulation de fréquence selon la revendication 3, caractérisée par le fait que le signal de commutation, dont il y a au moins un et qui active un circuit prévu pour la modification de la caractéristique de reprise du réglage de la fréquence centrale du filtre à fréquence intermédiaire et/ou de la commande de phase, forme en outre le signal d'entrée pour l'entrée de commande d'un étage de commutation (17 à 20),
est modifié pour réduire la réponse en fréquence de la reprise de réglage de la fréquence centrale du filtre et/ou la tension de commande de phase en fonction du rapport entre le niveau du canal voisin et le niveau du signal utile, et en particulier, en cas de traitement à fréquence intermédiaire à bande plus étroite, en direction des hautes fréquences,
pour mettre hors circuit le signal de commande pour la modulation de phase lors de la reprise de réglage de la fréquence centrale du filtre, en particulier dans le cas d'un traitement à fréquence intermédiaire a large bande et/ou
pour mettre totalement hors circuit la reprise de réglage de la fréquence centrale du filtre en cas de détection d'un saut de tension prédéterminé dans le signal à fréquence intermédiaire et/ou dans les fréquences les plus basses du signal basse fréquence, provoqué par une brève prise en charge du canal voisin.

6. Partie d'un récepteur à modulation de fréquence selon l'une des revendications précédentes, caractérisée par le fait que forment au moins un signal d'entrée pour la partie (28) de reconnaissance du signal:
le signal de sortie d'un filtre passe-bande à fréquence intermédiaire (6), qui n'est concerné ni par les commutations, ni par les mises en circuit ou hors circuit des chemins du signal, et qui fournit une fréquence intermédiaire réglée sur une valeur moyenne fixe et/ou
le signal de sortie d'un circuit intégrateur (27a) amené en tant que signal d'entrée pour l'étage de régulation pour la régulation d'amplitude du signal à fréquence intermédiaire, et/ou
le signal à fréquence intermédiaire démodulé.

7. Partie d'un récepteur à modulation de fréquence selon la revendication 1, caractérisée par le fait que sont prévus des moyens de compensation (8a) de l'amplitude du signal à fréquence intermédiaire, moyens qui, lors d'un affaiblissement du signal à fréquence intermédiaire à l'intérieur du circuit de régulation par suite d'un signal de commande approprié, compensent simultanément l'abaissement de niveau qui en résulte de façon que la tension de régulation pour l'amplitude du signal à fréquence intermédiaire y conserve sensiblement son niveau.

8. Partie d'un récepteur à modulation de fréquence selon la revendication 1, caractérisée par le fait qu'un étage de commutation (114, 116) avec hystérésis est prévu en cas de modification de la réponse en fréquence de transmission ou de modification de l'amplitude sur un chemin de transmission du signal, étage qui modifie le seuil de passage en monophonie d'une valeur telle, par rapport au seuil de réponse, que la modification opérée par la commutation, en ce qui concerne le signal à comparer avec le seuil du signal, est au moins compensée, en particulier telle que la réduction du signal de reconnaissance du canal voisin à la suite du traitement de la fréquence intermédiaire en bande plus étroite est au moins compensée en fonction de la réponse de l'étage de reconnaissance pour les perturbations provoquées par le canal voisin.

9. Partie d'un récepteur à modulation de fréquence selon la revendication 1, caractérisée par le fait que sont prévus des moyens logiques de commutation (601, 606) qui, en cas de modification de la réponse en fréquence de transmission ou de l'amplification sur un chemin de transmission du signal, en présence de plusieurs seuils de réponse prévus, les signaux à comparer avec les seuils de réponse étant majorés d'un signal déclenché par le dépassement par valeur inférieure, interdisent la réponse de l' tage à valeur de seuil correspondant au seuil de commutation de valeur inférieure la plus proche, jusqu'à ce que le seuil de commutation de valeur supérieure la plus proche ait répondu.

10. Partie d'un récepteur à modulation de fréquence selon la revendication 1, caractérisée par le fait que sont prévus des moyens logiques de commutation (200) qui, dans le cas de signaux de sortie du circuit de préparaiion du signal qui conduisent à des signaux de commande qui, en plus d'une diminution de la largeur de bande passante en fréquence intermédiaire, déclenchent encore d'autres commutations, n'autorisent que les signaux de sortie du circuit de préparation du signal qui conduisent à la bande passante de la réponse en fréquence intermédiaire chaque fois la plus étroite.
